(19) Europäisches Patentamt
European Patent Office
Office européen des brevets

(11) EP 4 307 020 A1

(12) **EUROPEAN PATENT APPLICATION**
published in accordance with Art. 153(4) EPC

(43) Date of publication:
**17.01.2024 Bulletin 2024/03**

(21) Application number: **22767271.4**

(22) Date of filing: **11.03.2022**

(51) International Patent Classification (IPC):
***G02B 5/22*** (2006.01) ***C09K 3/00*** (2006.01)
***G02B 1/11*** (2015.01) ***G02B 1/16*** (2015.01)
***G02B 1/18*** (2015.01) ***G02B 5/00*** (2006.01)
***G02B 5/02*** (2006.01) ***G09F 9/00*** (2006.01)
***G09F 9/30*** (2006.01)

(52) Cooperative Patent Classification (CPC):
**C09K 3/00; G02B 1/11; G02B 1/16; G02B 1/18; G02B 5/00; G02B 5/02; G02B 5/20; G02B 5/22; G09F 9/00; G09F 9/30**

(86) International application number:
**PCT/JP2022/010930**

(87) International publication number:
**WO 2022/191317 (15.09.2022 Gazette 2022/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.03.2021 JP 2021040751**

(71) Applicant: **TOPPAN INC.**
**Tokyo 110-0016 (JP)**

(72) Inventors:
- **ISHIKAWA Shinya**
  **Tokyo 110-0016 (JP)**
- **ISHIMARU Yoshiko**
  **Tokyo 110-0016 (JP)**
- **FUTAMATA Kai**
  **Tokyo 110-0016 (JP)**

(74) Representative: **TBK**
**Bavariaring 4-6**
**80336 München (DE)**

# (54) ADHESIVE SHEET, OPTICAL SHEET, DISPLAY DEVICE AND ADHESIVE LAYER-FORMING COMPOSITION

(57) An adhesive sheet includes: a colored adhesive layer formed of one or more layers comprising a first colorant in which the maximum absorption wavelength is in the range of 470 nm or more and 530 nm or less and the half width of absorption spectrum thereof is 15 nm or more and 45 nm or less, a second colorant in which the maximum absorption wavelength is in the range of 560 nm or more and 620 nm or less and the half width of absorption spectrum thereof is 15 nm or more and 55 nm or less, and a third colorant in which, in the wavelength range of 400 nm or more and 800 nm or less, the wavelength with a lowest transmittance is in the range of 650 nm or more and 780 nm or less; and a UV absorbing adhesive layer disposed on the surface of the colored adhesive layer and having a UV shielding rate of 85% or more according to JIS L 1925. The color hues a* and b* of the adhesive sheet are each in the range of -5 or more and +5 or less.

FIG.1

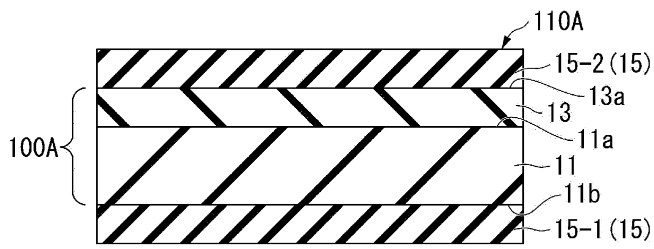


EP 4 307 020 A1

## Description

[Technical Field]

The present invention relates to adhesive sheets, optical sheets, display devices, and adhesive layer-forming compositions.

The present application claims the benefit of priority from Japanese Patent Application No. 2021-040751 filed March 12, 2021, the content of which is incorporated herein by reference.

[Background Art]

Self-luminescent display devices including self-luminescent elements, such as organic light-emitting devices, have high suitability for miniaturization, and have good properties, such as low power consumption, high luminance, and high reaction speed, unlike liquid crystal display devices and the like, and are expected to be used in next-generation display devices. Such self-luminescent display devices have a display surface including an area in which metal electrodes or wiring are formed. These metal electrodes or wiring, which reflect externally incident light (i.e., external light), tend to cause deterioration in display quality such as deterioration in contrast.

In order to suppress such deterioration in display quality, there is proposed, for example, a self-luminescent display device with a configuration in which a polarization plate and a phase retardation plate are disposed on the surface of the display device. However, in the configuration of using a polarization plate and a phase retardation plate, most of the light emitted from the display device tends to be lost when discharged to the outside via the polarization plate and the phase retardant plate, and the device life is easily reduced.

Display devices are required to have high color purity. Color purity, which refers to range of colors that can be displayed by display devices, is also called color reproduction range. Accordingly, having high color purity means having a wide color reproduction range with good color reproducibility. Known methods of improving color reproducibility include a method in which colors are separated by providing color filters to a light source emitting white light, or a method in which a light source emitting monochromatic light of three primary colors RGB is corrected using color filters to reduce the spectral half-width. However, improving color reproducibility of display devices using color filters involves increasing the thickness of the color filters or increasing the concentration of colorants, raising issues of deterioration in display quality such as deterioration in pixel shape or viewing angle characteristics. In addition, production processing of display devices emitting monochromatic light of three primary colors RGB requires the formation of color filters, and this raises an issue of cost increase.

As a display device with a configuration different from the configuration including the polarization plate and the phase retardation plate or different from the configuration using color filters, PTL 1 discloses a display device with a configuration including optical filters comprising colorants that selectively absorb predetermined wavelength bands. These optical filters selectively absorb light in wavelength bands that particularly reduce color purity in light emitted from the display device, and therefore, suppress loss of light required for displaying the three primary colors emitted from the organic light-emitting devices and improve visibility of the displayed image. However, these disclosed techniques are insufficient in the effect of suppressing deterioration in display quality due to reflection of external light and allow the reflected light to become tinted. As an optical filter for absorbing light of a specific wavelength, PTL 2 discloses an adhesive film comprising a specific color correction dye and a UV stabilizer. However, these disclosed optical filters are insufficient in reliability related to light resistance or heat resistance and thus are difficult to put into practical use.

[Citation List]

[Patent Literatures]

PTL 1: JP 2019-56865 A

PTL 2: JP 5917659 B

[Summary of the Invention]

[Technical Problem]

The optical filter disclosed in PTL 1 contains a colorant having a maximum absorption wavelength in the first

wavelength band of 480 nm to 510 nm and a colorant having a maximum absorption wavelength in the second wavelength band of 580 nm to 610 nm, and further contains colorants having maximum absorption wavelengths in the respective wavelength bands of 650 nm to 710 nm and 360 nm to 420 nm to suppress luminance deterioration and improve color purity. When such an optical filter containing these colorants absorbing light having specific wavelengths is used in display devices, external light reflectance or reflection characteristics, such as reflection hue due to external light reflection, can be varied; however, PTL 1 does not disclose any method of adjusting external light reflection luminance or reflection hue, although it discloses a method of adjusting transmission characteristics according to the emission light source of the display device. Therefore, it has been difficult to use these types of optical filters as reflection reducing members. Thus, display quality improvement and prolonging life of light-emitting devices have been demanded in the optical filters of the conventional art and in the field of display devices, such as organic light-emitting display devices.

In light of the above circumstances, the present invention provides an adhesive sheet, an optical sheet including the adhesive sheet, a display device, and an adhesive layer-forming composition for the adhesive sheet, which can improve display quality and prolong life of light-emitting devices.

[Solution to Problem]

In order to solve the above issues, an adhesive sheet according to a first aspect of the present invention includes: a colored adhesive layer formed of one or more layers comprising a first colorant in which a maximum absorption wavelength is in a range of 470 nm or more and 530 nm or less and a half width of absorption spectrum thereof is 15 nm or more and 45 nm or less, a second colorant in which a maximum absorption wavelength is in a range of 560 nm or more and 620 nm or less and a half width of absorption spectrum thereof is 15 nm or more and 55 nm or less, and a third colorant in which, in a wavelength range of 400 nm or more and 780 nm or less, a wavelength with a lowest transmittance is in a range of 650 nm or more and 780 nm or less; and a UV absorbing layer disposed on one surface of the colored adhesive layer and having a UV shielding rate of 85% or more according to JIS L 1925, wherein chromaticity indices a* and b* of reflection color hue defined by the following Formulas (1) to (9) are each in a range of -5 or more and +5 or less.

When a D65 illuminant is applied to the UV absorbing layer from a side facing away from the surface contacting the colored adhesive layer in the thickness direction, and when a reflectance $R_E(\lambda)$ at the lowermost layer portion of the adhesive sheet is taken to be 100% at all the wavelengths in the wavelength range of 380 nm to 780 nm, a* and b* are calculated from a light emission-side reflectance $R(\lambda)$.

[Math. 1]

$$a^* = 500\left\{f\left(\frac{X}{X_n}\right) - f\left(\frac{Y}{Y_n}\right)\right\} \quad \cdots (1)$$

[Math. 2]

$$b^* = 200\left\{f\left(\frac{Y}{Y_n}\right) - f\left(\frac{Z}{Z_n}\right)\right\} \quad \cdots (2)$$

[Math. 3]

$$f(t) = \begin{cases} t^{\frac{1}{3}} & \left[t > \left(\frac{6}{29}\right)^3\right] \\ \frac{1}{3}\left(\frac{29}{6}\right)^2 t + \frac{4}{29} & \left[t \le \left(\frac{6}{29}\right)^3\right] \end{cases} \quad \cdots (3)$$

[Math. 4]

$$R1(\lambda)[\%]=\frac{(100-R2(\lambda))}{100}\times\frac{T(\lambda)}{100}\times\frac{T(\lambda)}{100}\times R_E(\lambda) \quad \cdots (4)$$

[Math. 5]

$$R(\lambda)[\%] = R1(\lambda) + R2(\lambda) \quad \cdots (5)$$

[Math. 6]

$$X = k \times \int_{380}^{780} P_{D65}(\lambda) \times R(\lambda) \times \bar{x}(\lambda)\, d\lambda \quad \cdots (6)$$

[Math. 7]

$$Y = k \times \int_{380}^{780} P_{D65}(\lambda) \times R(\lambda) \times \bar{y}(\lambda)\, d\lambda \quad \cdots (7)$$

[Math. 8]

$$Z = k \times \int_{380}^{780} P_{D65}(\lambda) \times R(\lambda) \times \bar{z}(\lambda)\, d\lambda \cdots (8)$$

[Math. 9]

$$k = 100 \Big/ \int_{380}^{780} P_{D65}(\lambda) \times \bar{y}(\lambda)\ d\lambda \quad \cdots (9)$$

In these formulas:

λ is a variable representing wavelength, t is a variable representing a ratio of X, Y or Z to $X_n$, $Y_n$ or $Z_n$, respectively, *a and *b calculated from Formulas (1) to (3) are calculated according to a calculation method in a CIE1976L*a*b* color space (CIELAB color space), and $X_n$, $Y_n$, $Z_n$ in Formulas (1) and (2) represent tristimulus values at the white point of the D65 illuminant,
$R_E(\lambda)$ in Formula (4) is a function representing a reflectance [%] of a perfectly diffusely reflecting surface (defined to be 100% at each wavelength), R2(λ) is a function representing a surface reflectance [%] on an outermost surface of the adhesive sheet facing away from a surface of the UV absorbing layer contacting the colored adhesive layer, T(λ) is a function representing a transmittance [%] of the adhesive sheet,
$P_{D65}(\lambda)$ in Formulas (6) to (9) is a D65 illuminant spectrum, and $\bar{x}(\lambda)$, $\bar{y}(\lambda)$ or $\bar{z}(\lambda)$ is a color matching function of CIE1931 at 2° field of view, and
definite integrals in Formulas (6) to (9) can be obtained by appropriate numerical integration, and wavelength intervals for numerical integration are, for example, 1 nm intervals.

In Formula (5), R(λ) represents a reflectance of the optical film for light incident on the UV absorbing layer from the surface facing away from the surface contacting the colored adhesive layer, considering internal reflection in the adhesive sheet.

X, Y or Z in Formulas (6) to (8) represents a tristimulus value at the white point of the D65 illuminant.

An optical sheet according to a second aspect of the present invention includes: the adhesive sheet described

above; and an optical function layer which is disposed on an external light-incident side with respect to the UV absorbing layer and reduces reflection of the external light, wherein the optical function layer is either an antiglare layer, or an antireflection layer including a high refractive index layer or a low refractive index layer.

A display device according to a third aspect of the present invention includes: a luminescent layer; and the adhesive sheet or the optical sheet described above which is disposed to face a light emission surface of the luminescent layer from above in a traveling direction of light emitted from the luminescent layer.

An adhesive layer-forming composition according to a fourth aspect of the present invention comprises: an adhesive, a dye, and an additive, wherein the dye contains at least one of a first colorant in which a maximum absorption wavelength is in a range of 470 nm or more and 530 nm or less and a half width of absorption spectrum thereof is in a range of 15 nm or more and 45 nm or less, and a second colorant in which a maximum absorption wavelength is in a range of 560 nm or more and 620 nm or less and a half width of absorption spectrum thereof is in a range of 15 nm or more and 55 nm or less, and contains a third colorant in which, in a wavelength range of 400 nm or more and 780 nm or less, a wavelength with a lowest transmittance is in a range of 650 nm or more and 780 nm or less; and the additive contains at least one of a radical scavenger, peroxide decomposer, and singlet oxygen quencher.

[Advantageous Effects of the Invention]

According to the present invention, there can be provided an adhesive sheet, an optical sheet, a display device, and a colored adhesive layer-forming composition, which can improve display quality in the presence of external light reflection and can prolong life of the light-emitting devices of the display device.

[Brief Description of the Drawings]

Fig. 1 is a cross-sectional view illustrating an adhesive sheet according to a first embodiment of the present invention.

Fig. 2 is a diagram illustrating a method of calculating chromaticity indices a* and b* of reflection hue for the adhesive sheet according to the present invention.

Fig. 3 is a cross-sectional view illustrating a display device according to the present invention.

Fig. 4 is a cross-sectional view illustrating the adhesive sheet shown in Fig. 1 and a display device including the adhesive sheet.

Fig. 5 is a cross-sectional view illustrating an adhesive sheet according to a second embodiment of the present invention.

Fig. 6 is a cross-sectional view illustrating an adhesive sheet according to a third embodiment of the present invention.

Fig. 7 is a cross-sectional view illustrating an adhesive sheet and an optical sheet according to a fourth embodiment of the present invention.

Fig. 8 is a cross-sectional view illustrating an adhesive sheet and an optical sheet according to a fifth embodiment of the present invention.

Fig. 9 is a cross-sectional view illustrating an adhesive sheet and an optical sheet according to a sixth embodiment of the present invention.

Fig. 10 is a graph showing spectrum during white display, emitted by an organic EL light source and color filters in an example.

Fig. 11 shows electrode reflectance of an organic EL display device, based on which display device reflection characteristics 2 and display device reflection hue 2 are calculated in an example.

Fig. 12 is a graph of spectra outputted through an organic EL light source and color filters during display of red, green and blue colors.

[Description of the Embodiments]

With reference to the drawings, embodiments of the present invention will be described. Throughout the drawings, the same reference signs are given to the same or corresponding components between different embodiments to omit duplicate description.

(First Embodiment)

As shown in Fig. 1, an adhesive sheet 100A according to a first embodiment of the present invention includes at least a colored adhesive layer 11 and a UV absorbing adhesive layer (UV absorbing layer) 13.

The colored adhesive layer 11 is formed of an adhesive layer-forming composition. The adhesive layer-forming

composition contains an adhesive, dye, and additive. The adhesive contained in the colored adhesive layer 11 may be, for example, a resin exhibiting adhesiveness, such as silicone adhesives, acrylic adhesives, and urethane adhesives, but is not particularly limited thereto.

The colored adhesive layer 11 is formed of one or more layers comprising first to third colorants as a dye. In other words, the dye contains first to third colorants. Figs. 1 and 2 show a colored adhesive layer 11 formed of a single layer. The first colorant has a maximum absorption wavelength in the range of 470 nm or more and 530 nm or less. The half width of the absorption spectrum peak of the first colorant is 15 nm or more and 45 nm or less. In the present specification, the term maximum absorption wavelength refers to a wavelength having a greatest absorbance among the maximum values of absorptance in absorption spectra. The second colorant has a maximum absorption wavelength in the range of 560 nm or more and 620 nm or less. The half width of the absorption spectrum peak of the second colorant is 15 nm or more and 55 nm or less. The third colorant is not particularly limited in terms of maximum absorption wavelength, and refers to a colorant which, in the wavelength range of 400 nm or more and 780 nm or less, has a lowest transmittance wavelength in the range of 650 nm or more and 780 nm or less. The light absorption spectrum of the entire colored adhesive layer 11 of the adhesive sheet 100A shows peaks of maximum absorption wavelengths of the first to third colorants.

In the following description, if the first to third colorants are collectively referred to, they are simply referred to as colorants.

The first to third colorants contained in the colored adhesive layer 11 are preferred to contain a compound having a structure, for example, of any of a porphyrin structure, merocyanine structure, phthalocyanine structure, azo structure, cyanine structure, squarylium structure, coumarin structure, polyene structure, quinone structure, tetradiporphyrin structure, pyrromethene structure, and indigo structure, and one or more compounds selected from the group consisting of metal complexes of these compounds. It is particularly preferred to use a compound having a porphyrin structure, pyrromethene structure, phthalocyanine structure, or squarylium structure in the molecule.

The adhesive layer-forming composition forming the colored adhesive layer 11 may not comprise a dye having a main absorption wavelength band in the wavelength range of 390 nm to 435 nm, and accordingly, the colored adhesive layer 11 may not comprise a dye having a main absorption wavelength band in the wavelength range of 390 nm to 435 nm.

The colored adhesive layer 11 may comprise a dye having a main absorption wavelength band in the wavelength range of 390 nm to 435 nm; however, dyes having a main absorption wavelength band in the wavelength range of 390 nm to 435 nm do not have a function of improving reliability in terms of light resistance or heat resistance which the present invention aims. Accordingly, in order to simply adjust the color characteristics of the colored adhesive layer 11, the colored adhesive layer 11 may comprise a dye having a main absorption wavelength band in the wavelength range of 390 nm to 435 nm. The UV absorbing layer 13 and/or a UV absorbing layer 17 (second embodiment) above the colored adhesive layer 11 may comprise a dye having a main absorption wavelength band in the wavelength range of 390 nm to 435 nm so that reliability for the colored adhesive layer 11 can be improved.

The colored adhesive layer 11 is preferred to comprise at least one of a radical scavenger, peroxide decomposer, and singlet oxygen quencher as an additive. With these additives contained, color fading of the colorant contained in the colored adhesive layer 11 due to light, heat, and the like can be suppressed and thus durability can be improved.

Radical scavengers can suppress dye deterioration (color fading) due to containing constituent materials having a function of capturing radicals and suppressing autoxidation when dyes undergo oxidative deterioration. If a hindered amine light stabilizer with a molecular weight of 2,000 or more is used as a radical scavenger, a strong effect of preventing color fading can be achieved. Radical scavengers with a low molecular weight are easily volatilized and fewer molecules can remain in the colored layer and thus it is difficult to achieve sufficient effect of suppressing color fading. Examples of the material preferred to be used as such a radical scavenger include Chimassorb (trademark) 2020FDL, Chimassorb (trademark) 944FDL, and Tinuvin (trademark) 622 all manufactured by BASF Corporation, and LA-63P manufactured by ADEKA Corporation.

Singlet oxygen quenchers have a function of inactivating highly reactive singlet oxygen, which easily causes dyes to undergo oxidative deterioration (color fading) to suppress oxidative deterioration (color fading) of dyes. Singlet oxygen quenchers may include transition metal complexes, dyes, amines, phenols, and sulfides, but materials particularly preferred may be transition metal complexes of dialkyl phosphate, dialkyldithiocarbamate or benzenedithiol, with nickel, copper or cobalt being preferably used as the central metal. For example, NKX1199, NKX113 and NKX114 manufactured by Hayashibara Co., Ltd. (KANKOHSHA), and D1781, B1350, B4360 and T3204 manufactured by Tokyo Chemical Industry Co., Ltd can be mentioned.

Peroxide decomposers have a function of decomposing peroxides produced when dyes undergo oxidative deterioration and stopping the autoxidation cycle to suppress dye deterioration (color fading). Such peroxide decomposers are preferred to contain a constituent material that can inactivate hydroperoxides, examples of which include phosphorus antioxidants and sulfur antioxidants.

Examples of the phosphorus antioxidants include 2,2'-methylenebis(4,6-di-t-butyl-1-phenyloxy)(2-ethylhexyloxy)phosphorus, 3,9-bis(2,6-di-tert-butyl-4-methylphenoxy)-2,4,8,10-tetraoxa-3,9-diphosphaspiro[5.5]undecane, and

6-[3-(3-t-butyl-4-hydroxy-5-methylphenyl)propoxy]-2,4,8,10-tetra-t-butyldibenz[d,f][1,3,2]dioxaphosphepine.

Examples of the sulfur antioxidants include 2,2-bis({[3-(dodecylthio)propionyl]oxy}methyl)-1,3-propanediyl-bis[3-(dodecylthio)propionate], 2-mercaptobenzimidazole, dilauryl-3,3'-thiodipropionate, dimyristyl-3,3'-thiodipropionate, distearyl-3,3'-thiodipropionate, pentaerythrityl-tetrakis(3-laurylthiopropionate), and 2-mercaptobenzothiazole.

The UV absorbing adhesive layer 13 is disposed on a surface (one surface) 11a of the colored adhesive layer 11. The UV absorbing adhesive layer 13 is preferred to have a UV shielding rate of 85% or more. In the present specification, the term UV shielding rate refers to a UV shielding rate measured according to JIS L 1925 and indicating a value [%] obtained by subtracting an average shielding rate (unit; [%]) in the wavelength range of 290 nm to 400 nm from 100%.

The UV absorbing adhesive layer 13 comprises a UV absorber having a UV shielding rate of 85% or more and an adhesive. Examples of the UV absorber include benzophenone-, benzotriazole-, triazine-, oxalic acid anilide-, and cyanoacrylate-based compounds. Examples of the adhesive contained in the UV absorbing adhesive layer 13 include resins exhibiting adhesiveness, such as silicone adhesives, acrylic adhesives, and urethane adhesives, and the adhesive may be the same type of adhesive contained in the colored adhesive layer 11, but is not particularly limited thereto.

The adhesive sheet 100A can be produced, for example, by forming one of the colored adhesive layer 11 and the UV absorbing adhesive layer 13 on a base film made of a resin or the like, and forming the other of these layers thereon, followed by separating the base film. The colored adhesive layer 11 and the UV absorbing adhesive layer 13 can each be formed by applying a coating liquid containing constituent materials of the layer, followed by drying. The base film does not have to be separated from either of the colored adhesive layer 11 and the UV absorbing adhesive layer 13, but may be used as a covering layer 15 described later.

In the adhesive sheet 100A, if light emitted from the D65 illuminant is incident on the adhesive sheet 100A from a surface 13a of the UV absorbing adhesive layer 13 (surface facing away from the surface contacting the colored adhesive layer, i.e., from above the UV absorbing adhesive layer) in the thickness direction, and if a reflectance R(λ) of light perfectly diffusely reflected at a surface 11b of the lowermost layer of the adhesive sheet is measured from the light emission side, chromaticity indices (values) a* and b* of the reflection hue of the adhesive sheet expressed by the above Formulas (1) to (9) may each be in the range of -5 or more and +5 or less. The above hue, which is represented by a 3D Cartesian coordinate with three values of a lightness index L* expressed by Formula (10) as well as the above Formulas (1) and (2) as axes, is one of the uniform color spaces defined by the International Commission on Illumination (CIE) (also referred to as CIE 1976 L *a*b* color spaces or CIE LAB color spaces).

[Math. 10]

$$L^* = 116\left(\frac{Y}{Y_n}\right)^{\frac{1}{3}} - 16 \quad \cdots (10)$$

Herein, Y is a tristimulus value of the reflected light of the D65 illuminant at the reflectance R(λ) and is calculated from the above Formulas (4), (5), (7) and (9), and $Y_n$ is a tristimulus value at the white point of the D65 illuminant.

Referring to Fig. 2, a method of calculating chromaticity indices a* and b* as indicators of external light reflection hue of the adhesive sheet of the present invention will be described.

As shown in Fig. 2, if the D65 illuminant is applied to the UV absorbing adhesive layer 13 of the adhesive sheet 100A in the thickness direction from the surface (outermost surface) 13a facing away from the surface contacting the colored adhesive layer 11, the reflected light from the adhesive sheet 100A can be divided into a surface reflection component and an internal reflection component. The surface reflection component is defined by a surface reflectance R2(λ) [%] at the surface 13a, and the internal reflection component is defined by R1(λ) [%] calculated using Formula (4) based on a reflectance $R_E$(λ) [%] of a perfectly diffusely reflecting surface that is defined to be 100% at all wavelengths, a transmittance T(λ) [%] in the adhesive sheet 100A, and the surface reflectance R2(λ) [%] on the surface 13a. When the surface 13a-side reflectance of the adhesive sheet 100A, to which the D65 illuminant is applied, is R(λ) [%], R(λ) can be calculated from the above Formula (5).

Similarly to R1(λ) and R2(λ), since R(λ) is a function of wavelength λ, the tristimulus value X, Y, Z can be calculated by calculating a definite integral with respect to λ of Formulas (6) to (9). Herein, the definite integral may be calculated by numerical integration as appropriate. For example, the numerical integration may be performed at equal intervals of 1 nm.

As described above, X, Y, Z in Formulas (1) and (2) are the three tristimulus values for reflected light with the reflectance R(λ) for the D65 illuminant at the surface 13a of the adhesive sheet 100A, and $X_n$, $Y_n$, $Z_n$ represent the tristimulus values at the white point of the D65 illuminant. Based on these values, the chromaticity indices a* and b* which are indicators of the external light reflection hue of the adhesive sheet 100A can be calculated. From the perspective of enhancing display quality in the presence of external light reflection, the chromaticity indices (values) a* and b* of the

hue of the adhesive sheet 100A are preferred to be in the range of -5 or more and + 5 or less. The internal reflectances occurring on the inner surfaces such as of the display parts or the electrode wiring parts of self-luminescent display devices such as organic luminous display devices generally depend on the wavelengths in the wavelength range of 380 nm to 780 nm. In this regard, as a result of diligent studies made in the present invention, it has been found that, under conditions where $R_E(\lambda)$ is a reflectance of a perfectly diffusely reflecting surface that is defined to be 100% at all the wavelengths, and the chromaticity indices (values) a* and b* of the reflection hue at the adhesive sheet 100A due to external light are each in the range of -5 or more and +5 or less, if $R_E(\lambda)$ is replaced by the actual internal reflectance of a luminescent layer 35 of a self-luminescent display device, the chromaticity indices a* and b*, i.e., the indicators of the external light reflection hue, are also in the range of -5 or more and +5 or less, thus achieving good display quality.

The adhesive sheet 100A is configured such that desired separate optical equipment or optical materials can be disposed on the surface 11b of the colored adhesive layer 11 facing away from the surface 11a and on the surface 13a of the UV absorbing adhesive layer 13. As shown in Fig. 1, in the state in which no desired optical equipment or optical materials are disposed thereto, the surfaces 11b and 13a having viscosity are detachably provided with covering layers 15-1 and 15-2 in order to prevent adhesion of dirt thereto. In other words, the adhesive sheet 110A includes the colored adhesive layer 11, the UV absorbing adhesive layer 13, and the covering layers 15-1 and 15-2. Hereinafter, when details common to the covering layers 15-1 and 15-2 are described, these covering layers are collectively referred to as covering layers 15.

Any type of release material or separator may be used for the covering layers 15, for example. The separator may be a resin film or paper, for example.

The covering layer 15-1 of the adhesive sheet 110A can be separated from the colored adhesive layer 11, so that a luminescent layer 35 can be disposed on the surface 11b of the colored adhesive layer 11 without gaps. Also, the covering layer 15-2 of the adhesive sheet 110A can be separated from the UV absorbing adhesive layer 13, so that a protective layer 200 can be disposed on the surface 13a of the UV absorbing adhesive layer 13 without gaps. Thus, by providing the luminescent layer 35 and the protective layer 200 to the adhesive layer 100A, a display device 120A as shown in Fig. 3 can be configured.

As shown in Fig. 3, the display device 120A of the present invention includes the luminescent layer 35 and the adhesive sheet 100A. The adhesive sheet 100A is disposed to face the light emission surface of the luminescent layer 35 from above via color filters 33 in a traveling direction E1 of light emitted from the luminescent layer 35.

The luminescent layer 35 includes a substrate 31, light-emitting devices 32-1, 32-2, 32-3, and the color filters 33. The substrate 31 may be formed of a silicon (Si) substrate, for example. The light-emitting devices 32-1, 32-2, 32-3 are embedded in the substrate 31 and emit white light, for example. The light-emitting devices 32-1, 32-2, 32-3 have respective emission surfaces exposed at a surface 31a of the substrate 31. The light-emitting devices 32-1, 32-2, 32-3 may be, for example, organic EL devices.

In the direction intersecting the thickness direction and parallel to the surface 11b, the color filters 33 are defined into a red transmission area 33-R, green transmission area 33-G, and blue transmission area 33-B in a unit area of each pixel. From the red transmission area 33-R, red light in the white light emitted from the light-emitting device 32-1 is emitted from a surface 33a of the color filter 33 in the traveling direction E1. From the green transmission area 33-G, green light in the white light emitted from the light-emitting device 32-1 is emitted from the surface 33a of the color filter 33 in the traveling direction E1. From the blue transmission area 33-B, blue light in the white light emitted from the light-emitting device 32-1 is emitted from the surface 33a of the color filter 33 in the traveling direction E1.

The protective layer 200 is provided in order to protect the luminescent layer 35 and the adhesive sheet 100A from external impact or the like (from above in Fig. 1). The protective layer 200 has optical characteristics not greatly affecting the transmission spectrum of at least visible light in the light emitted from the surface 13a of the UV absorbing adhesive layer 13 of the adhesive sheet 100A in the traveling direction E1. The expression "not greatly affecting the transmission spectrum" refers to that, when hue expressed on a surface 200a of the protective layer 200 is measured in the direction opposite to the traveling direction E1, the chromaticity indices a* and b* expressed by the above Formulas (1) to (3) are each in the range of -5 or more and +5 or less. The protective layer 200 is formed, for example, of glass, resin film, or resin plate transparent to visible light. In the present specification, visible light refers to light having an emission wavelength band of 380 nm to 780 nm.

(Modification of first embodiment)

In the adhesive sheet 100A, 110A of the first embodiment, the colored adhesive layer 11 is configured by a single layer comprising the first to third colorants; however, it may be configured by two or more layers. As shown in Fig. 4, the colored adhesive layer 11 may have a three-layer structure in which a colored adhesive layer 12-1 comprising only the first colorant, a colored adhesive layer 12-2 comprising only the second colorant, and a colored adhesive layer 12-3 comprising only the third colorant are laminated in the thickness direction. The three-layer structure as a whole may only have to comprise the first to third colorants, and the order of lamination of the colored layers 12-1, 12-2, 12-3

is not particularly limited. Although not shown, the colored adhesive layer 11 may include a first colored adhesive layer comprising the third colorant and one of the first and second colorants, and a second colored adhesive layer comprising the third colorant and the other of the first and second colorants.

An adhesive sheet 100A' as a modification of the first embodiment including two or more colored adhesive layers exhibits the same effect as that of the adhesive sheet 100A. As shown in Fig. 4, similarly to the adhesive sheet 100A, the adhesive sheet 100A' may be combined with a luminescent layer 35 and a protective layer 200 to configure a display device 120A'.

The adhesive layer-forming composition of the present embodiment can form the adhesive sheet 100A, 100A' of the first embodiment and the modification thereof, and comprises an adhesive, dye, and additive. The dye contained in the adhesive-layer forming composition forming the adhesive sheet 100A comprises the first, second and third colorants, while the adhesive layer-forming composition forming the adhesive sheet 100A' comprises the third colorant and one of the first and second colorants.

(Second Embodiment)

Next, an adhesive sheet and other components of a second embodiment of the present invention will be described. It should be noted that, in the second and the subsequent embodiments, only differences from the above-described embodiments will be described, and details and explanations common to the above embodiments will be basically omitted. In the explanations of the configurations of the second and the subsequent embodiments, components common to the above-described embodiments will be given the same reference signs as those of the above-described embodiments to omit description.

As shown in Fig. 5, an adhesive sheet 100B according to the second embodiment of the present invention includes a colored adhesive layer 11 and a UV absorbing transparent substrate (UV absorbing layer) 17. Hereinafter, the UV absorbing transparent substrate may simply be referred to as transparent substrate. The UV absorbing transparent substrate 17 is disposed on a surface 11a of the colored adhesive layer 11. The UV absorbing transparent substrate 17 comprises a UV absorber and functions as a UV shielding layer, while being formed of a material having a UV shielding rate of 85% or more and having good visible light transmission. As main forming materials of the UV absorbing transparent substrate 17 other than the UV absorber, transparent resins such as polyolefins such as polyethylene and polypropylene, polyesters such as polyethylene terephthalate, polybutylene terephthalate and polyethylene naphthalate, polyacrylates such as polymethyl methacrylate, polyamides such as nylon 6 and nylon 66, polyimides, polyarylates, polycarbonates, triacetyl cellulose, polyvinyl alcohol, polyvinyl chloride, cycloolefin copolymers, norbornene-containing resins, polyethersulfone and polysulfone, or inorganic glass can be used. Of these materials, films formed of polyethylene terephthalate (PET), films formed of triacetyl cellulose (TAC), films formed of polymethyl methacrylate (PMMA), and films formed of polyesters can be preferably used. The UV absorbing transparent substrate 17 is preferred to have a thickness of 10 $\mu$m to 100 $\mu$m, but is not limited thereto.

The UV absorbency of the transparent substrate 17 can be imparted, for example, by blending a resin material for forming the transparent substrate 17 with a UV absorber. The UV absorber that can be used include benzophenone-, benzotriazole-, triazine-, oxalic acid anilide-, and cyanoacrylate-based compounds, but it is not particularly limited thereto.

The adhesive sheet 100B is configured such that desired separate optical equipment or optical materials can be disposed on a surface 1 1b of the colored adhesive layer 11. In other words, the adhesive sheet 110B includes the colored adhesive layer 11, the UV absorbing transparent substrate 17, and a covering layer 15-1. Although not shown, the covering layer 15-1 of the adhesive sheet 110B can be separated from the colored adhesive layer 11, so that the luminescent layer 35 described in the first embodiment can be disposed on the surface 11b of the colored adhesive layer 11 without gaps.

The adhesive sheet 100B, 110B of the second embodiment described above and display devices including the adhesive sheet 100B, 110B exhibit the same effect as that of the adhesive sheet 100A, 110A and the display device 120A of the first embodiment. According to the adhesive sheet 100B, 110B of the second embodiment, the UV absorbing transparent substrate 17 can function as a protective layer or cover in a state of being disposed at the outermost surface of the entire structure, and therefore, thickness reduction with simplified assembling processing can be achieved for devices and the like to which the adhesive sheet 100B, 110B is applied.

The modification for the adhesive sheet 100A, 110A of the first embodiment can be similarly applied to the adhesive sheet 100B, 110B of the second embodiment.

(Third Embodiment)

Next, an adhesive sheet and other components of a third embodiment of the present invention will be described.

As shown in Fig. 6, an adhesive sheet 100C according to the third embodiment of the present invention includes a colored adhesive layer 11, a UV absorbing transparent substrate (UV absorbing layer) 17, and an oxygen barrier layer

20. The oxygen barrier layer 20 is provided to the UV absorbing transparent substrate 17 side, that is, provided to a layer above a surface 11a of the colored adhesive layer 11. In the adhesive sheet 100C shown in Fig. 6, the oxygen barrier layer 20 is provided closer to the UV absorbing transparent substrate 17 than the colored adhesive layer 11 in the thickness direction.

The oxygen barrier layer 20 is preferred to have an oxygen permeability of 10 cc/$m^2$·day·atm or less, and more preferably 5 cc/$m^2$·day·atm or less. As main constituent materials, the oxygen barrier layer 20 is preferred to comprise polyvinyl alcohol (PVA), ethylene-vinyl alcohol copolymer (EVOH), vinylidene chloride, siloxane resin, or the like, and specifically MAXIVE (trademark) manufactured by Mitsubishi Gas Chemical Company, Inc., EVAL or POVAL manufactured by Kuraray Co., Ltd., Saran Latex or Saran Resin manufactured by Asahi Kasei Corporation, or the like can be used. The thickness of the oxygen barrier layer 20 is not particularly limited, but may have a thickness with which desired oxygen barrier properties can be achieved.

The oxygen barrier layer 20 may comprise dispersed inorganic particles (particles of inorganic compounds). Such inorganic particles can further reduce oxygen permeability and further suppress oxidative deterioration (color fading) of a colored layer 21. The size and content of the inorganic particles are not particularly limited, but may be appropriately determined according to the thickness or the like of the oxygen barrier layer 20. The size (greatest length) of the inorganic particles dispersed in the oxygen barrier layer 20 is preferred to be less than the thickness of the oxygen barrier layer 20. Smaller size is more advantageous. The size of the inorganic particles dispersed in the oxygen barrier layer 20 may be uniform or non-uniform. Specifically, the inorganic particles dispersed in the oxygen barrier layer 20 may be silica particles, alumina particles, silver particles, copper particles, titanium particles, zirconium particles, tin particles, or the like.

The adhesive sheet 100C is configured such that desired separate optical equipment or optical materials can be disposed on a surface 11b of the colored adhesive layer 11. Specifically, as shown in Fig. 6, the adhesive sheet 110C may include the colored adhesive layer 11, the UV absorbing transparent substrate 17, the oxygen barrier layer 20, and a covering layer 15-1. Although not shown, the covering layer 15-1 of the adhesive sheet 110C can be separated from the colored adhesive layer 11, so that a luminescent layer 35 can be disposed on the surface 11b of the colored adhesive layer 11 without gaps.

The adhesive sheet 100C, 110C of the third embodiment described above and display devices including the adhesive sheet 100C, 110C exhibit the same effect as that of the adhesive sheet 100A, 110A and the display device 120A of the first embodiment.

The adhesive sheet 100C, 110C of the third embodiment includes the oxygen barrier layer 20 having an oxygen permeability of 10 cc/$m^2$·day·atm or less on a surface 17a of the UV absorbing transparent substrate 17. Deterioration in light resistance of dyes can be said to be oxidative deterioration due to the presence of oxygen. According to the adhesive sheet 100C, 110C, oxygen contained in the outside air neither permeates the oxygen barrier layer 20 in the thickness direction, nor reaches the colored adhesive layer 11, and therefore, the first to third colorants contained in the colored adhesive layer 11 can be prevented from being deteriorated by oxygen in the outside air. Accordingly, light absorption performance of the colored adhesive layer 11 can be maintained for a long period of time. In other words, the adhesive sheet 100C, 110C can suppress deterioration of the colored adhesive layer 11 attributed to chemical reaction with oxygen.

The modification for the adhesive sheet 100A, 110A of the first embodiment can be similarly applied to the adhesive sheet 100C, 110C of the third embodiment.

(Fourth Embodiment)

Next, an adhesive sheet and other components of a fourth embodiment of the present invention will be described.

As shown in Fig. 7, an adhesive sheet 100D according to the fourth embodiment of the present invention includes a colored adhesive layer 11, a UV absorbing transparent substrate (UV absorbing layer) 17, and a hard coating layer 22.

The hard coating layer 22 is disposed on a surface 17a of the UV absorbing transparent substrate 17 facing away from the colored adhesive layer 11 in the thickness direction. The hard coating layer 22 is a rigid layer formed of a resin or the like and is provided to enhance scratch resistance of an optical sheet 130D described below. The hard coating layer 22 is preferred to have a pencil hardness of H or higher at 500 g load at the surface. The pencil hardness is measured based on JIS-K 5600-5-4:1999. Examples of the constituent material of the hard coating layer 22 include urethane (meth)acrylate, polyester (meth)acrylate, and epoxy (meth)acrylate. It may be simple and easy to form the hard coating layer 22 using an energy ray-curable compound such as a UV curable resin. In this case, the hard coating layer 22 can be formed by applying a coating liquid containing at least an energy ray-curable compound, polymerization initiator, and solvent, to the UV absorbing transparent substrate 17, and applying corresponding energy rays for curing. The composition for forming the hard coating layer 22 may contain metal oxide microparticles for the purpose of adjusting refractive index or imparting hardness, or may contain any of silicon oxides, fluorine-containing silane compounds, fluoroalkyl

silazanes, fluoroalkylsilanes, fluorine-containing silicon compounds, and perfluoropolyether group-containing silane coupling agents for the purpose of imparting water repellency and/or oil repellency and imparting antifouling properties, or may contain conductive materials such as quaternary ammonium cations and conductive metal microparticles for the purpose of imparting antistatic properties, or may contain other materials. The metal oxide microparticles may be zirconium oxide, titanium oxide, niobium oxide, antimony trioxide, antimony pentoxide, tin oxide, indium oxide, indium tin oxide, zinc oxide, or the like. As necessary, a leveling agent, antifoaming agent, photosensitizer, or the like may be contained.

An optical sheet 130D of the present invention includes the adhesive sheet 100D, and a low refractive index layer (optical function layer, antireflection layer) 24. The low refractive index layer 24 is provided on a surface 22a of the hard coating layer 22 facing away from the UV absorbing transparent substrate 17 in the thickness direction. In other words, in the optical sheet 130D, the low refractive index layer 24 is disposed on the external light-incident side with respect to the UV absorbing transparent substrate 17. The low refractive index layer 24 has a refractive index lower than that of the hard coating layer 22 and is provided to reduce reflection of external light incident on the optical sheet 130D (i.e., reflection toward the observer). The low refractive index layer 24 can be formed by curing a coating liquid containing at least an active energy ray-curable resin. The resins described for the hard coating layer 22 can be used as the active energy ray-curable resin. Microparticles such as of LiF, MgF, 3NaF·AlF, AlF and $Na_3AlF_6$, silica microparticles, or other microparticles may be blended to adjust refractive index. In order to reduce refractive index of the low refractive index layer, it is effective to use particles with voids inside, such as porous silica microparticles and hollow silica microparticles, as silica microparticles. Also, a photopolymerization initiator or solvent, or other additives may be appropriately blended. The refractive index of the low refractive index layer 24 is preferred to be 1.20 to 1.55. The thickness of the low refractive index layer 24 is not particularly limited but is preferred to be 40 nm to 1 $\mu$m.

The low refractive index layer 24 may comprise any of silicon oxides, fluorine-containing silane compounds, fluoroalkyl silazanes, fluoroalkylsilanes, fluorine-containing silicon compounds, and perfluoropolyether group-containing silane coupling agents. These materials can impart water repellency and/or oil repellency to the low refractive index layer 24 to enhance antifouling properties thereof.

The adhesive sheet 100D or the optical sheet 130D is configured such that desired separate optical equipment or optical materials can be disposed on a surface 11b of the colored adhesive layer 11. Specifically, the adhesive sheet 110D may include the colored adhesive layer 11, the UV absorbing transparent substrate 17, the hard coating layer 22, the low refractive index layer 24, and a covering layer 15-1. Although not shown, the covering layer 15-1 of the adhesive sheet 110D can be separated from the colored adhesive layer 11, so that a luminescent layer 35 can be disposed on the surface 11b of the colored adhesive layer 11 without gaps.

The adhesive sheet 100D, 110D and the optical sheet 130D of the fourth embodiment described above and display devices including the adhesive sheet 100D, 110D exhibit the same effect as that of the adhesive sheet 100A, 110A and the display device 120A of the first embodiment.

Also, with the hard coating layer 22 provided on the surface 17a of the UV absorbing transparent substrate 17, the adhesive sheet 100D, 110D of the fourth embodiment can enhance scratch resistance against external impact or the like.

The optical sheet 130D of the present invention includes the adhesive sheet 100D and an optical function sheet which is disposed on the external light-incident side with respect to the UV absorbing transparent substrate 17 of the adhesive sheet 100D to reduce surface reflection of external light. The above optical function layer is the low refractive index layer 24 functioning as an antireflection layer. The optical sheet 130D can prevent strong surface reflection of external light, and therefore, can enhance visibility of the contents displayed on the display device or the like to which the optical sheet 130D is applied.

The modification for the adhesive sheet 100A, 110A of the first embodiment can be similarly applied to the adhesive sheet 100D, 110D and the optical sheet 130D of the fourth embodiment.

(Fifth Embodiment)

Next, an adhesive sheet and other components of a fifth embodiment of the present invention will be described.

As shown in Fig. 8, an adhesive sheet 100E according to the fifth embodiment of the present invention includes a colored adhesive layer 11 and a UV absorbing transparent substrate (UV absorbing layer) 17.

An optical sheet 130E of the present invention includes the adhesive sheet 100E and an antiglare layer (optical function layer) 26. The antiglare layer 26 is disposed on a surface 17a of the UV absorbing transparent substrate 17 facing away from the colored adhesive layer 11 in the thickness direction. The antiglare layer 26, if applied to display devices or the like, reduces reflection of light (i.e., regular reflection or specular reflection) from the position of the display screen and prevents glare. The antiglare layer 26 can be formed by curing a coating liquid containing an active energy ray-curable resin and, as necessary, organic microparticles and/or inorganic microparticles. The resins described for the hard coating layer 22 can be used as the active energy ray-curable resin. The thickness of the antiglare layer 26 is

not particularly limited but is preferred to be 1 μm to 10 μm. The organic microparticles form asperities on the surface of the antiglare layer 26 to impart thereto an ability to diffuse external light. Examples of the organic microparticles that can be used include resin particles of translucent resin materials such as acrylic resins, polystyrene resins, styrene-(meth)acrylic acid ester copolymers, polyethylene resins, epoxy resins, silicone resins, polyvinylidene fluoride, and polyethylene fluoride resins. Two or more types of resin particles of different materials (different refractive indices) may be mixed and used to adjust refractive index or dispersion of the resin particles. The inorganic microparticles adjust sedimentation or aggregation of the organic microparticles in the antiglare layer 26. Examples of the inorganic microparticles that can be used include silica microparticles, metal oxide microparticles, and various types of mineral microparticles.

The antiglare layer 26 may comprise any of silicon oxides, fluorine-containing silane compounds, fluoroalkyl silazanes, fluoroalkylsilanes, fluorine-containing silicon compounds, and perfluoropolyether group-containing silane coupling agents. By imparting water repellency and/or oil repellency to the antiglare layer 26 using these materials, antifouling properties of the optical sheet 130E and the adhesive sheet 100E can be enhanced.

By unevenly distributing materials, the antiglare layer 26 may be formed as a layer in which layers with relatively high refractive index and layers with relatively low refractive index are sequentially laminated from the UV absorbing transparent substrate 17 side. The antiglare layer 26 in which materials are unevenly distributed can be formed, for example, by applying a composition which contains a low refractive index material containing surface-modified silica microparticles or hollow silica microparticles, and a high refractive index material, and allowing phase separation to occur using the difference in surface free energy between the two materials. If the antiglare layer 26 is configured by two phase-separated layers, the layer with a relatively high refractive index on the colored adhesive layer 11 side is preferred to have a refractive index of 1.50 to 2.40, and the layer with a relatively low refractive index on the surface side of the antiglare layer 26 is preferred to have a refractive index of 1.20 to 1.55.

The adhesive sheet 100E or the optical sheet 130E is configured such that desired separate optical equipment or optical materials can be disposed on a surface 11b of the colored adhesive layer 11. Specifically, the adhesive sheet 110E may include the colored adhesive layer 11, the UV absorbing transparent substrate 17, the antiglare layer 26, and a covering layer 15-1. Although not shown, the covering layer 15-1 of the adhesive sheet 110E can be separated from the colored adhesive layer 11, so that a luminescent layer 35 can be disposed on the surface 11b of the colored adhesive layer 11 without gaps.

The adhesive sheet 100E, 110E, the optical sheet 130E of the fifth embodiment described above and display devices including the adhesive sheet 100E, 110E exhibit the same effect as that of the adhesive sheet 100A, 110A and the display device 120A of the first embodiment.

The optical sheet 130E of the present invention includes the adhesive sheet 100E and the antiglare layer 26 as an optical function layer which is disposed on the external light-incident side with respect to the UV absorbing transparent substrate 17 of the adhesive sheet 100E and reduces reflection of external light. According to the optical sheet 130E, external light can be scattered and diffused in the antiglare layer 26, and therefore, surface reflection of external light can be suppressed for the contents displayed on the display devices or the like to which the optical sheet 130E is applied. Accordingly, the optical sheet 130E can improve visibility of the contents and images displayed on the display devices, and can suppress deterioration in display quality due to reflection of external light.

The modification for the adhesive sheet 100A, 110A of the first embodiment can be similarly applied to the adhesive sheet 100E, 110E and the optical sheet 130E of the fifth embodiment.

(Sixth embodiment)

Next, an optical sheet and other components of the present invention will be described.

As shown in Fig. 9, an optical sheet 130F of the present invention includes an adhesive sheet 100E, an antiglare layer (optical function layer, antireflection layer) 26, and a low refractive index layer (optical function layer, antireflection layer) 24. In a sixth embodiment, the low refractive index layer 24 is provided on a surface 26a of the antiglare layer 26 facing away from the UV absorbing transparent substrate 17 in the thickness direction.

The optical sheet 130F is configured such that desired separate optical equipment or optical materials can be disposed on a surface 11b of the colored adhesive layer 11. Specifically, an adhesive sheet 110F may include the colored adhesive layer 11, the UV absorbing transparent substrate 17, the antiglare layer 26, the low refractive index layer 24, and a covering layer 15-1. Although not shown, the covering layer 15-1 of the adhesive sheet 110F can be separated from the colored adhesive layer 11, so that a luminescent layer 35 can be disposed on the surface 11b of the colored adhesive layer 11 without gaps.

Optical devices including the optical sheet 130F and the adhesive sheet 110F described above exhibit the same effect as that of the adhesive sheet 100A, 110A and the display device 120A of the first embodiment.

The optical sheet 130F of the present invention includes the adhesive sheet 100E, and the antiglare layer 26 and the low refractive index layer 24 as optical function layers which are disposed on the external light-incident side with

respect to the UV absorbing transparent substrate 17 of the adhesive sheet 100E. According to the adhesive sheet 110F and the optical sheet 130F, external light can be scattered and diffused in the antiglare layer 26 and strong reflection of external light can be suppressed in the low refractive index layer 24, and therefore, glare, surface reflection, or the like of external light can be suppressed for the contents displayed on the display devices or the like to which the adhesive sheet 110F or the optical sheet 130F is applied. Accordingly, the adhesive sheet 110F or the optical sheet 130F can improve visibility of the contents and images displayed on the display devices to which these components are applied, and can suppress deterioration in display quality due to reflection of external light.

The modification for the adhesive sheet 100A, 110A of the first embodiment can be similarly applied to the adhesive sheet 110F and the optical sheet 130F of the sixth embodiment.

Preferred embodiments of the present disclosure have been described so far, but the present invention should not be limited to these specific embodiments. The present invention can be modified within the scope of the invention recited in the claims.

For example, in the adhesive sheet of the present invention, the colored adhesive layer is preferred to comprise at least one of a radical scavenger, peroxide decomposer, and singlet oxygen quencher. The types of the radical scavenger, peroxide decomposer, and singlet oxygen quencher are not limited to the materials described above, but may be changed to appropriate materials.

For example, the optical function layer which is disposed on the external light-incident side with respect to the UV absorbing layer of the adhesive sheet of the present invention and reduces reflection of external light should not be limited to the low refractive index layer or the antiglare layer described above. The optical function layer may be a high refractive index layer (optical function layer, antireflection layer), antistatic layer, or antifouling layer. In other words, the optical sheet of the present invention may further include an antistatic layer or antifouling layer. The high refractive index layer may have a refractive index lower than that of the UV absorbing transparent layer 17 and, similarly to the low refractive index layer described above, may be provided to reduce reflection of external light incident on the optical sheet (i.e., reflection toward the observer). Constituent materials of the high refractive index layer may be active energy ray-curable resins, photopolymerization initiators, solvents, or the like. The antistatic layer may be provided to prevent charging of the adhesive sheet or the display device and may comprise an antistatic agent. Constituent materials of the antistatic layer may include ionizing radiation-curable materials, polymerization initiators, and antistatic agents. The antistatic agents may include metal oxide microparticles such as of antimony-doped tin oxide (ATO) and tin-doped indium oxide (ITO), polymeric conductive compositions, and quaternary ammonium salts. The antifouling layer may be provided to prevent adhesion of dirt to the adhesive sheet or the display device and has water repellency, for example. Constituent materials of the antifouling layer may include silicon oxides, fluorine-containing silane compounds, fluoroalkyl silazanes, fluoroalkylsilanes, fluorine-containing silicon compounds, and perfluoropolyether group-containing silane coupling agents. The optical sheet of the present invention may include all of the optical function layer, antistatic layer, and antifouling layer. Furthermore, in the optical sheet of the present invention, the adhesive sheet may include any layer that does not greatly affect hue of the adhesive sheet and has desired functions.

For example, the configurations of the above embodiments may be combined as appropriate. As an example, an optical function layer such as a low refractive index layer or antiglare layer may be disposed between the oxygen barrier layer and the UV absorbing transparent substrate of the adhesive sheet of the third embodiment.

Also, the luminescent layer of the display device according to the present invention should not be limited to layers including organic EL devices, but may be layers including white LED devices, inorganic phosphor light-emitting devices, quantum dot light-emitting devices, or the like. The configuration of the luminescent layer should not be limited to the configuration provided with light-emitting devices emitting white light and color filters, but the configuration may be provided with light-emitting devices that can emit, for example, red (R), green (G), and blue (B) light.

## Examples

Hereinafter, examples will be described. However, the present invention should not be limited to the following examples.

In the following examples and comparative examples, Optical Sheets 1 to 19 with layer structures shown in Tables 1 and 2 were prepared, and Optical Sheets 1 to 16 as prepared were evaluated in terms of their characteristics. Furthermore, using Optical Sheets 5, 13 and 17 to 19, display device characteristics of an organic EL panel were simulated.

[Table 1]

| | | Ex. 1 | Ex.2 | Ex. 3 | Ex. 4 | Ex. 5 | Ex. 6 | Ex. 7 | Ex. 8 | Ex. 9 | Ex. 10 | Ex. 11 | Ex. 12 | Ex. 13 |
|---|---|---|---|---|---|---|---|---|---|---|---|---|---|---|
| | Optical sheet | Optical sheet 1 | Optical sheet 2 | Optical sheet 3 | Optical sheet 4 | Optical sheet 5 | Optical sheet 6 | Optical sheet 7 | Optical sheet 8 | Optical sheet 9 | Optical sheet 10 | Optical sheet 11 | Optical sheet 12 | Optical sheet 13 |
| | Function layer 1 | LRI layer | LRI layer | LRI layer | LRI layer | LRI layer | | | LRI layer | LRI layer | LRI layer | LRI layer | LRI layer | LRI layer |
| | Function layer 2 | Hard coating layer 1 | Hard coating layer 1 | Hard coating layer 1 | Hard coating layer 1 | Hard coating layer 1 | Hard coating layer 1 | Anti-glare layer | Anti-glare layer | Hard coating layer 1 | Hard coating layer 1 | Hard coating layer 1 | Hard coating layer 1 | Hard coating layer 1 |
| | Function layer 3 | - | - | Oxygen barrier layer | - | - | - | - | - | - | - | - | - | - |
| | Substrate | PMMA2 | TAC | TAC | TAC | TAC | TAC | TAC | TAC | PMMA1 | PET1 | PET2 | TAC | TAC |
| | Adhesive layer | Adhesive layer 9 | - | - | - | - | - | - | - | - | - | - | - | - |
| | Colored adhesive layer | Adhesive layer 1 | Adhesive layer 1 | Adhesive layer 1 | Adhesive layer 2 | Adhesive layer 3 | Adhesive layer 3 | Adhesive layer 3 | Adhesive layer 3 | Adhesive layer 3 | Adhesive layer 3 | Adhesive layer 3 | Adhesive layer 4 | Adhesive layer 6 |
| Adherend | | Glass | Glass | Glass | Glass | Glass | Glass | Glass | Glass | Glass | Glass | Glass | Glass | Glass |

[Table 2]

| | | Comp. Ex. 1 | Comp. Ex.2 | Comp. Ex. 3 | Comp. Ex.4 | Comp. Ex. 5 | Comp. Ex. 6 |
|---|---|---|---|---|---|---|---|
| | Optical sheet | Optical sheet 14 | Optical sheet 15 | Optical sheet 16 | Optical sheet 17 | Optical sheet 18 | Optical sheet 19 |
| | Function layer 1 | LRI layer | LRI layer | LRI layer | LRI layer | LRI layer | |
| | Function layer 2 | Hard coating layer 1 | Hard coating layer 2 | Hard coating layer 1 | Hard coating layer 1 | Hard coating layer 1 | Hard coating layer 1 |
| | Function layer 3 | - | - | - | - | - | - |
| | Substrate | PMMA2 | PMMA2 | PMMA2 | TAC | TAC | TAC |
| | Adhesive layer | - | - | - | - | - | Adhesive layer 10 |
| | Colored adhesive laver | Adhesive layer 1 | Adhesive layer 1 | Adhesive layer 5 | Adhesive layer 7 | Adhesive layer 8 | - |
| Adherend | | Glass | Glass | Glass | Glass | Glass | Glass |

<Preparation of organic sheet>

Hereinafter, methods of forming the individual layers will be described.

(Substrate)

The following films were used as substrates.

TAC: Triacetyl cellulose film (product name: TG60UL manufactured by FUJIFILM Corporation; substrate thickness 60 μm, UV shielding rate 92.9%)

PMMA1: Polymethyl methacrylate film (product name: W001U80 manufactured by Sumitomo Chemical Co., Ltd.; substrate thickness 80 μm, UV shielding rate 93.4%)

PMMA2: Polymethyl methacrylate film (product name: W002N80 manufactured by Sumitomo Chemical Co., Ltd.; substrate thickness 80 μm, UV shielding rate 13.9%)

PET1: Polyethylene terephthalate film (product name: SRF manufactured by Toyobo Co., Ltd.; substrate thickness 80 μm, UV shielding rate 88.3%)

PET2: Polyethylene terephthalate film (product name: TOR20 manufactured by SKC Co., Ltd.; substrate thickness 40 μm, UV shielding rate 88.6%)

(Preparation of optical function layer)

[Formation of oxygen barrier layer]

An 80 mass% aqueous solution of PVA117 (manufactured by Kuraray Co., Ltd.) was applied to the structure of Example 3 shown in Table 1 and dried to form an oxygen barrier layer with an oxygen permeability of 1 cc/m$^2$·day·atm.

(Formation of the hard coating layer)

(Hard coating layer-forming composition)

Using the following materials, the hard coating layer-forming compositions shown in Table 3 were prepared for forming hard coating layers.

Active energy ray-curable resin:

UA-306H (pentaerythritol triacrylate hexamethylene diisocyanate urethane prepolymer, manufactured by Kyoeisha Chemical Co., Ltd.)
DPHA (dipentaerythritol hexaacrylate)
PETA (pentaerythritol triacrylate)

Initiator:

Omnirad TPO (product name, manufactured by IGM Resins B.V)
Omnirad 184 (product name, manufactured by IGM Resins B.V.)
MEK (methyl ethyl ketone)
Methyl acetate

[Table 3]

| | | Hard coating layer 1 | Hard coating layer 2 |
|---|---|---|---|
| Active energy ray-curing resin | Type | UA-306H / DPHA / PETA | UA-306H / DPHA / PETA |
| | Ratio | 70/20/10 | 70/20/10 |
| | Addition amount | 45.4% | 42.2% |
| Photopolymerization initiator | Type | Omnirad TPO | Omnirad 184 |
| | Addition amount | 4.6% | 4.6% |
| UV absorbing agent | Type | - | Tinuvin 479 / LA36 |
| | Ratio | - | 40/60 |
| | Addition amount | - | 3% |
| Solvent | Type | MEK / Methyl acetate | MEK / Methyl acetate |
| | Ratio | 50/50 | 50/50 |
| | Addition amount | 50% | 50% |

The hard coating layer-forming compositions shown in Table 3 were applied to the substrates or oxygen barrier layers of the optical sheets shown in Tables 1 and 2, followed by drying in an oven at 80°C for 60 seconds, and curing by performing UV irradiation at an irradiation dose of 150 $mJ/cm^2$ using a UV irradiation device (light source: H bulb manufactured by Fusion UV Systems Japan), thereby forming the hard coating layers 1 and 2 shown in Tables 1 and 2 with a cured thickness of 5.0 $\mu$m.

[Formation of antiglare layer]

(Antiglare layer-forming composition)

The following antiglare layer-forming composition was used for forming an antiglare layer.
- Active energy ray-curable resin:

Light Acrylate PE-3A (manufactured by Kyoeisha Chemical Co., Ltd., refractive index 1.52) 43.7 parts by mass

- Photopolymerization initiator:

| | |
|---|---|
| Omnirad TPO (manufactured by IGM Resins B.V.) | 4.55 parts by mass |

- Resin particles:

| | |
|---|---|
| Styrene-methyl methacrylate copolymer particles (refractive index: 1.515, average particle size: 2.0 μm) | 0.5 parts by mass |

- Inorganic microparticles 1:

| | |
|---|---|
| Synthetic smectite | 0.25 parts by mass |

- Inorganic microparticles 2:

| | |
|---|---|
| Alumina nanoparticles, average particle size 40 nm | 1.0 part by mass |

- Solvent:

| | |
|---|---|
| Toluene | 15 parts by mass |
| Isopropyl alcohol | 35 parts by mass |

An antiglare-forming composition with the above formulation was applied to the substrates of the optical sheets of Examples 7 and 8 shown in Table 1, followed by drying in an oven at 80°C for 60 seconds, and curing by performing UV irradiation at an irradiation dose of 150 mJ/$cm^2$ using a UV irradiation device (light source: H bulb manufactured by Fusion UV Systems Japan), thereby forming the antiglare layers shown in Table 1 with a cured thickness of 5.0 μm.

[Formation of low refractive index layer]

(Low refractive index layer-forming composition)

The following low refractive index layer-forming composition was used for forming a low refractive index layer.
- Refractive index modifier:

| | |
|---|---|
| Porous silica microparticle dispersion (average particle size: 75 nm, solid content: 20%,solvent: methyl isobutyl ketone) | 8.5 parts by mass |

- Antifouling agent:

| | |
|---|---|
| Optool AR-110 (manufactured by Daikin Industries Ltd., solid content 15%, solvent:methyl isobutyl ketone) | 5.6 parts by mass |

- Active energy ray-curable resin:

| | |
|---|---|
| Pentaerythritol triacrylate | 0.4 parts by mass |

- Initiator:

| | |
|---|---|
| Omnirad 184 (product name, manufactured by IGM Resins B.V.) | 0.07 parts by mass |

- Leveling agent:

RS-77 (manufactured by DIC Corporation) 1.7 parts by mass

- Solvent:

Methyl isobutyl ketone 83.73 parts by mass

Alow refractive index layer-forming composition with the above formulation was applied to the hard coating layers or antiglare layers of the optical sheets shown in Tables 1 and 2, followed by drying in an oven at 80°C for 60 seconds, and curing by performing UV irradiation at an irradiation dose of 200 mJ/$cm^2$ using a UV irradiation device (light source: H bulb manufactured by Fusion UV Systems Japan), thereby forming the low refractive index layers shown in Tables 1 and 2 with a cured thickness of 100 nm.

[Preparation of adhesive layer]

(Preparation of base adhesive)

The following composition was used as a base adhesive.

- Adhesive resin:

| | |
|---|---|
| Butyl acrylate (BA)-hydroxyethyl methacrylate (HEMA) copolymer solution dissolved in ethyl acetate | 70 parts by mass |

- Curing agent:

Isocyanate cross-linking agent 0.037 parts by mass

- Additive:

Silane coupling agent 0.048 parts by mass

- Solvent:

Methyl ethyl ketone (MEK) 30 parts by mass

(Antiglare layer-forming composition)

The following materials were used for preparing the adhesive layer-forming compositions shown in Table 4 for forming adhesive layers. The greatest absorption wavelength and half width of each colorant were calculated from the spectral transmittance, as characteristic values in the adhesive layer.

- Base adhesive
- First colorant

Dye-1:

Pyrromethene cobalt complex dye expressed by the following Chemical Formula (1) (strongest absorption wavelength: 493 nm, half width: 26 nm)

-Second colorant

Dye-2:

Tetraazaporphyrin copper complex dye (product name: PD-311S manufactured by Yamamoto Chemicals Inc.,

strongest absorption wavelength: 584 nm, half width: 17 nm)

Dye-3:

Tetraazaporphyrin copper complex dye (product name: FDG-007 manufactured by Yamada Kagaku Co., Ltd., strongest absorption wavelength: 593 nm, half width: 18 nm)

- Third colorant:

Dye-4:

Phthalocyanine copper complex dye (product name: FDN-002 manufactured by Yamada Kagaku Co., Ltd., strongest absorption wavelength: 800 nm, lowest transmittance wavelength at 400 nm to 780 nm: 780 nm)

Dye-5:

Phthalocyanine cobalt complex dye (product name: FDR-002 manufactured by Yamada Kagaku Co., Ltd., strongest absorption wavelength: 683 nm, lowest transmittance wavelength at 400 nm or more and 780 nm or less: 683 nm)

- Additive:

  Hindered amine light stabilizer Chimassorb 944FDL (manufactured by BASF Japan Ltd., molecular weight: 2,000 to 3,100)
  Hindered amine light stabilizer Tinuvin 249 (manufactured by BASF Japan Ltd., molecular weight: 482)
  Singlet oxygen quencher D1781 (manufactured by Tokyo Chemical Industry Co., Ltd.) UV absorbing agent:

    Tinuvin 479 (manufactured by BASF Japan Ltd.)
    LA-36 (manufactured by ADEKA Corporation)

- Adhesive agent:
  Base adhesive prepared in the above
- Solvent:
  Ethyl acetate

The adhesive layer-forming compositions of the examples do not contain dyes having a main absorption wavelength band at a wavelength range of 390 nm to 435 nm.

[Chemical Formula 1]

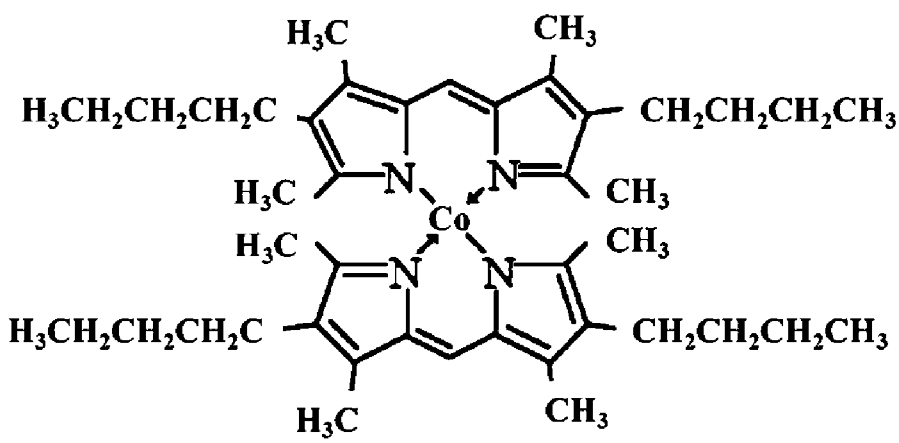

[Table 4]

| | | Adhesive layer 1 | Adhesive layer 2 | Adhesive layer 3 | Adhesive layer 4 | Adhesive layer 5 | Adhesive layer 6 | Adhesive layer 7 | Adhesive layer 8 | Adhesive layer 9 | Adhesive layer 10 |
|---|---|---|---|---|---|---|---|---|---|---|---|
| Colorant | First colorant | Dye-1 | | | | | | Dye-1 | Dye-1 | - | - |
| | Addition amount | 0.07% | | | | | 0.08% | 0.03% | 0.07% | - | - |
| | Second colorant | Dye-2 / Dye-3 | | | | | | Dye-2 / Dye-3 | Dye-2 / Dye-3 | - | - |
| | Ratio | 70/30 | | | | | 69/31 | 78/22 | 51/49 | - | - |
| | Addition amount | 0.13% | | | | | 0.12% | 0.17% | 0.28% | | |
| | Third colorant | Dye-4 / Dye-5 | | | | | | Dye-4 / Dye-5 | - | - | - |
| | Ratio | 76/24 | | | | | 74/26 | 76/24 | - | - | - |
| | Addition amount | 0.48% | | | | | 0.49% | 0.48% | - | - | - |
| Additive | Type | - | Chimassorb 944FDL | Chimassorb 944FDL/D1781 | Tinuvin 249 | Tinuvin 479/LA36 | Chimassorb 944FDL/D1781 | - | | Tinuvin 479/LA36 | - |
| | Ratio | - | 100 | 67/33 | 100 | 40/60 | 67/33 | - | - | 40/60 | - |
| | Addition amount | - | 0.35% | 0.52% | 0.35% | 0.77% | 0.52% | - | - | 0.77% | - |
| Adhesive | Addition amount | 84.71% | 84.21% | 83.97% | 84.21% | 83.61% | 83.96% | 84.71% | 85.18% | 84.58% | 85.68% |
| E. acetate | Addition amount | 14.61% | 14.76% | 14.83% | 14.76% | 14.94% | 14.83% | 14.61% | 14.47% | 14.65% | 14.32% |

(Preparation of adhesive layer and optical sheet)

Each adhesive obtained as described above was applied to a release substrate film so that the dry thickness would be 25 μm, followed by sufficient drying and laminating a release film, thereby obtaining an adhesive layer. After releasing the release film from one side, the obtained adhesive layer was bonded to a support made of alkali-free glass having a thickness of 0.7 mm. After that, the release film on the other side of the adhesive layer was released, and a substrate on which a function layer shown in Table 1 or 2 was laminated was bonded to the adhesive layer. In this way, optical sheets 1 to 19 were prepared.

[Evaluation of optical sheet characteristics]

(UV shielding rate of colored adhesive layer)

Transmittance of the optical function layer including the substrate above the colored adhesive layer of each of Examples 1 to 13 and Comparative Examples 1 to 3 was measured using an automatic spectrophotometer (U-4100 manufactured by Hitachi Ltd.). Based on these transmittances, an average transmittance of the UV region (wavelength band: 290 nm to 400 nm) was calculated, and a UV shielding rate [%] was calculate by substracting the average transmittance [%] of the UV region (wavelength band: 290 nm to 400 nm) from 100%.

(Pencil hardness test)

Using a Clemens type scratch hardness tester (HA-301 manufactured by Tester Sangyo Co., Ltd.), surfaces of the respective optical sheets were subjected to scratch hardness testing based on JIS-K 5600-5-4:1999, using a pencil (uni manufactured by Mitsubishi Pencil Co., Ltd., pencil hardness H) with a load of 500 gf (4.9 N) (termed 500 g load hereinafter). Then, changes in appearance due to scratches were visually evaluated. If no scratches were observed, the optical sheet was evaluated to be good, and if observed, was evaluated to be poor.

(Light resistance test)

The prepared optical sheets were subjected to reliability testing for 120 hours using a xenon weather meter tester (X75 manufactured by Suga Test Instruments Co., Ltd.) under conditions of xenon lamp illuminance 60 $W/cm^2$ (300 nm to 400 nm), and internal test machine temperature 45°C and humidity 50%RH. Before and after the testing, transmittance was measured using an automatic spectrophotometer (U-4100 manufactured by Hitachi Ltd.) to calculate a difference $\Delta T\lambda 1$ between transmittances before and after testing at a wavelength of $\lambda 1$ that had a smallest transmittance in the wavelength range of 470 nm to 530 nm before testing, a difference $\Delta T\lambda 2$ between transmittances before and after testing at a wavelength of $\lambda 2$ that had a smallest transmittance in the wavelength range of 560 nm to 620 nm before testing, and a difference $\Delta T\lambda 3$ between transmittances before and after testing at a wavelength of $\lambda 3$ that had a smallest transmittance in the wavelength range of 650 nm to 780 nm before testing. The transmittance difference closer to zero is better. Specifically, transmittance is preferred to be $|\Delta T\lambda N| \leq 20$ (N=1 to 3), and is more preferred to be $|\Delta T\lambda N| \leq 10$ (N=1 to 3).

Results of evaluation for the above items are shown in Tables 5 and 6.

[Table 5]

| | | Ex. 1 | Ex. 2 | Ex. 3 | Ex. 4 | Ex. 5 | Ex. 6 | Ex. 7 | Ex. 8 | Ex. 9 | Ex. 10 | Ex. 11 | Ex. 12 | Ex. 13 |
|---|---|---|---|---|---|---|---|---|---|---|---|---|---|---|
| UV shielding rate on adhesive layer | | 91.4% | 93.0% | 93.0% | 93.0% | 93.0% | 93.0% | 93.0% | 93.0% | 93.5% | 88.5% | 88.8% | 93.0% | 93.0% |
| Pencil hardness | | Good | Good | Good | Good | Good | Good | Good | Good | Good | Good | Good | Good | Good |
| Light resistance of adhesive layer | ΔTλ1 | 19.2 | 19.8 | 6.4 | 9.1 | 6.0 | 6.3 | 6.7 | 6.2 | 5.8 | 7.5 | 7.2 | 19.6 | 7.1 |
| | ΔTλ2 | 7.5 | 5.1 | 3.5 | 3.1 | 1.2 | 1.5 | 1.3 | 1.0 | 0.9 | 1.5 | 1.2 | 4.6 | 1.1 |
| | ΔTλ3 | 12.5 | 11.3 | 2.8 | 6.4 | 4.5 | 4.8 | 4.3 | 4.1 | 4.0 | 4.8 | 4.5 | 10.8 | 4.8 |

[Table 6]

| | | Comp. Ex. 1 | Comp. Ex. 2 | Comp. Ex. 3 |
|---|---|---|---|---|
| UV shielding rate on adhesive layer | | 19.6% | 91.4% | 19.6% |
| Pencil hardness | | Good | Poor | Good |
| Light resistance of adhesive layer | ΔTλ1 | 41.4 | 19.8 | 49.1 |
| | ΔTλ2 | 46.0 | 8.0 | 25.0 |
| | ΔTλ3 | 27.6 | 13.2 | 22.0 |

As shown in Tables 5 and 6, light resistance of the colored adhesive layers comprising the first to third colorants was greatly improved by providing a UV absorbing layer having a UV shielding rate of 85% or more as an upper layer. Only a small effect is produced by imparting a UV absorbing ability to the colored adhesive layer, and therefore, it is preferred that a separate layer is formed as an upper layer. Furthermore, light resistance of the colored adhesive layer was further improved by laminating an oxygen shielding layer and having the colored adhesive layer contain a high molecular weight hindered amine light stabilizer as a radical scavenger and contain a dialkyldithiocarbamate nickel complex as a singlet oxygen quencher.

[Evaluation for display device characteristics]

Prepared Optical sheets 5, 13 and 17 to 19 were evaluated as follows.

(White display transmission characteristics)

Transmittance of the prepared optical sheets was measured using an automatic spectrophotometer (U-4100 manufactured by Hitachi Ltd.), and the efficiency of light that transmitted through each optical sheet during white display was calculated using the transmittance to evaluate white display transmission characteristics. The efficiency was calculated as a ratio to the intensity of light that transmitted through the optical sheet at each wavelength, taking the intensity of light emitted from the white organic EL light source (which may be termed organic EL light source hereinafter) and outputted through the color filters at each wavelength during white display to be 100. The higher the light intensity ratio, the higher the luminous efficiency of the light source. Fig. 10 shows a spectrum of light emitted from the organic EL light source.

(Display device reflection characteristics 1)

For the prepared optical sheets, transmittance T(λ) and surface reflectance R2(λ) were measured using an automatic spectrophotometer (U-4100 manufactured by Hitachi Ltd.). The surface reflectance R2(λ) was measured by measuring spectral reflectance at an incident angle of 5° after applying a matt black paint to the surface of glass, as an adherend, on which no adhesive layer was formed, for antireflection treatment. A relative reflection value was calculated, taking an electrode reflectance $R_E(\lambda)$ to be 100% for all the wavelengths of 380 nm to 780 nm and taking the panel reflection value to be 100 for the D65 illuminant with no optical sheet disposed thereon, based on the above Formulas (4), (5), (7) and (9) without considering interface reflection and surface reflection at each layer, and the calculated value was evaluated as display device reflection characteristics 1. As relative reflection becomes lower, reflected light intensity is reduced accordingly, and display quality is improved.

(Display device reflection hue 1)

For the prepared optical sheets, transmittance T(λ) and surface reflectance R2(λ) were measured using an automatic spectrophotometer (U-4100 manufactured by Hitachi Ltd.). The surface reflectance R2(λ) was measured by measuring spectral reflectance at an incident angle of 5° after applying a matt black paint to the surface of glass, as an adherend, on which no adhesive layer was formed, for antireflection treatment. Chromaticity indices a* and b* of reflection hue for the D65 illuminant were calculated, taking the electrode reflectance $R_E(\lambda)$ to be 100% for all the wavelengths of 380 nm to 780 nm, based on the above Formulas (1) to (9) without considering interfacial reflection and surface reflection at each layer, and the calculated value was evaluated as display device reflection hue 1. The chromaticity indices a* and b* closer to zero are better, being less tinged with color, and thus these indices are preferred to be -5 or more and

+5 or less.

(Display device reflection characteristics 2)

A value was calculated similarly to display device reflection characteristics 1 except that the electrode reflectance shown in Fig. 11 obtained through reflectance measurement using an organic light-emitting display device (organic EL TV, OLED55C8PJA manufactured by LG Electronics) was used as the electrode reflectance $R_E(\lambda)$, and the calculated value was evaluated as display device reflection characteristics 2.
Similarly to display device reflection characteristics 1, as relative reflection becomes lower, reflected light intensity is reduced accordingly, and display quality is improved.

(Display device reflection hue 2)

A value was calculated similarly to display device reflection hue 1 except that the electrode reflectance shown in Fig. 11 obtained through reflectance measurement using an organic light-emitting display device (organic EL TV, OLED55C8PJA manufactured by LG Electronics) was used as the electrode reflectance $R_E(\lambda)$, and the calculated value was evaluated as display device reflection characteristics 2.
Similarly to display device reflection hue 1, the chromaticity indices a* and b* closer to zero are better, being less tinged with color, and thus these indices are preferred to be -5 or more and +5 or less.

(Color reproducibility)

Transmittance of each prepared optical sheet was measured using an automatic spectrophotometer (U-4100 manufactured by Hitachi Ltd.), and using this transmittance together with the red, green and blue display spectra shown in Fig. 12 outputted through the organic EL light source that emitted the spectrum shown in Fig. 10 and through the color filters, a CIE1931 chromaticity value was calculated, based on which an NTSC ratio was calculated to evaluate color reproducibility. Higher NTSC ratio can make the color reproducibility higher, which is preferable.
Results of evaluation for the above items are shown in Table 7.

[Table 7]

| | | Ex. 5 | Ex. 13 | Comp. Ex. 4 | Comp. Ex. 5 | Comp. Ex. 6 |
|---|---|---|---|---|---|---|
| White display transmission characteristics | | 52.1 | 52.0 | 52.6 | 51.1 | 91.4 |
| | Ratio to Comp. Ex. 6 | 57% | 57% | 58% | 56% | 100% |
| Display device reflection characteristics 1 | | 25.7 | 25.8 | 25.7 | 25.8 | 83.7 |
| | Ratio to Comp. Ex. 6 | 31% | 31% | 31% | 31% | 100% |
| Display device reflection hue 1 | a* | 3.9 | 3.2 | 5.8 | 27.3 | -0.2 |
| | b* | -4.7 | -3.5 | -19.8 | -16.6 | 0.9 |
| Display device reflection Characteristics 2 | | 11.2 | 11.2 | 11.2 | 11.4 | 34.8 |
| | Ratio to Comp. Ex. 6 | 32% | 32% | 32% | 33% | 100% |
| Display device reflection hue 2 | a* | 4.1 | 3.6 | 5.2 | 21.6 | 1.4 |
| | b* | -1.5 | -0.7 | -12.3 | -9.4 | 2.7 |
| Color reproducibility | Ratio to NTSC | 98.0% | 97.8% | 99.4% | 102.6% | 91.7% |

As shown in Table 7, reflection characteristics of the display devices provided with a colored adhesive layer were significantly reduced.
It is said that circular polarizers reduce transmittance by half, whereas the display devices including a colored adhesive layer exhibited good luminance efficiency and further improved color reproducibility, as indicated by the evaluation values for white display transmission. In the display devices of the examples including a colored adhesive layer comprising the first, second and third colorants, the absorption intensities of the colorants were adjustable so that the chromaticity indices a* and b* of reflection hue were in the range of -5 or more and +5 or less in the case where the electrode reflectance $R_E(\lambda)$ was taken to be 100% for all the wavelengths in the range of 380 nm to 780 nm. In other words, reflection hue could be brought close to neutral. These characteristics also showed that reflection hue was maintained

to be neutral and display quality of display devices was improved, even in the display device reflection hue 2 in which the electrode transmittance was changed to that of the actual organic light-emitting display device. As described above, as an aspect of the present invention, the blending ratio of the first, second and third colorants can be adjusted for the electrode reflectance of organic light-emitting display devices having various wavelength dispersions, so that the reflection hue of the optical sheet including the colored adhesive layer can be neutral.

Preferred embodiments and modifications of the present invention, together with examples, have been described above; however, the present invention is not limited to these embodiments and the examples. Additions, omissions, substitutions, and other changes can be made in the configuration without departing from the spirit of the present invention.

Furthermore, the present invention should not be limited by the foregoing description, but should be limited only by the appended claims.

[Industrial Applicability]

According to the present invention, there can be provided an adhesive sheet, an optical sheet, a display device, and a colored adhesive layer-forming composition, which can improve display quality in the presence of external light reflection and can increase the life of the light-emitting devices of the display device.

[Reference Signs List]

11 Colored adhesive layer
13 UV absorbing adhesive layer (UV absorbing layer)
17 UV absorbing transparent substrate (UV absorbing layer)
100A, 100A', 100B, 100C, 100D, 100E, 110A, 110B, 110C, 110D, 110E, 110F Adhesive sheet
120A, 120A' Display device
130D, 130E, 130F Optical sheet

**Claims**

**1.** An adhesive sheet comprising

a colored adhesive layer formed of one or more layers comprising a first colorant in which a maximum absorption wavelength is in a range of 470 nm or more and 530 nm or less and a half width of absorption spectrum thereof is 15 nm or more and 45 nm or less, a second colorant in which a maximum absorption wavelength is in a range of 560 nm or more and 620 nm or less and a half width of absorption spectrum thereof is 15 nm or more and 55 nm or less, and a third colorant in which, in a wavelength range of 400 nm or more and 780 nm or less, a wavelength with a lowest transmittance is in a range of 650 nm or more and 780 nm or less; and
a UV absorbing layer disposed on one surface of the colored adhesive layer and having a UV shielding rate of 85% or more according to JIS L 1925, wherein
color hues a* and b* defined by the following Formulas (1) to (9) are each in a range of -5 or more and +5 or less.

[Math. 1]

$$a^* = 500\left\{f\left(\frac{X}{X_n}\right) - f\left(\frac{Y}{Y_n}\right)\right\} \quad \cdots (1)$$

[Math. 2]

$$b^* = 200\left\{f\left(\frac{Y}{Y_n}\right) - f\left(\frac{Z}{Z_n}\right)\right\} \quad \cdots (2)$$

[Math. 3]

$$f(t) = \begin{cases} t^{\frac{1}{3}} & \left[t > \left(\frac{6}{29}\right)^3\right] \\ \frac{1}{3}\left(\frac{29}{6}\right)^2 t + \frac{4}{29} & \left[t \le \left(\frac{6}{29}\right)^3\right] \end{cases} \quad \cdots (3)$$

[Math. 4]

$$R1(\lambda)[\%] = \frac{(100 - R2(\lambda))}{100} \times \frac{T(\lambda)}{100} \times \frac{T(\lambda)}{100} \times R_E(\lambda) \quad \cdots (4)$$

[Math. 5]

$$R(\lambda)[\%] = R1(\lambda) + R2(\lambda) \quad \cdots (5)$$

[Math. 6]

$$\mathrm{X} = \mathrm{k} \times \int_{380}^{780} P_{D65}(\lambda) \times R(\lambda) \times \bar{x}(\lambda)\, d\lambda \quad \cdots (6)$$

[Math. 7]

$$\mathrm{Y} = \mathrm{k} \times \int_{380}^{780} P_{D65}(\lambda) \times R(\lambda) \times \bar{y}(\lambda)\, d\lambda \quad \cdots (7)$$

[Math. 8]

$$\mathrm{Z} = \mathrm{k} \times \int_{380}^{780} P_{D65}(\lambda) \times R(\lambda) \times \bar{z}(\lambda)\, d\lambda \cdots (8)$$

[Math. 9]

$$\mathrm{k} = 100 \Big/ \int_{380}^{780} P_{D65}(\lambda) \times \bar{y}(\lambda)\, d\lambda \quad \cdots (9)$$

where

λ is a variable representing wavelength, t is a variable representing a ratio of X, Y or Z to $X_n$, $Y_n$ or $Z_n$, respectively, *a and *b calculated from Formulas (1) to (3) are calculated according to a calculation method in a CIE1976L*a*b* color space (CIELAB color space), and $X_n$, $Y_n$, $Z_n$ in Formulas (1) and (2) represent tristimulus values at the white point of the D65 illuminant,

$R_E(\lambda)$ in Formula (4) is a function representing a reflectance [%] of a perfectly diffusely reflecting surface (defined to be 100% at each wavelength), R2(λ) is a function representing a surface reflectance [%] on an outermost surface of the adhesive sheet facing away from a surface of the UV absorbing layer of the adhesive sheet, the

surface of the UV absorbing layer contacting the colored adhesive layer, $T(\lambda)$ is a function representing a transmittance [%] of the adhesive sheet,
$P_{D65}(\lambda)$ in Formulas (6) to (9) is a D65 illuminant spectrum, and $\bar{x}(\lambda)$, $\bar{y}(\lambda)$ or $\bar{z}(\lambda)$ is a color matching function of CIE1931 at 2° field of view, and
definite integrals in Formulas (6) to (9) can be obtained by appropriate numerical integration, and wavelength intervals for numerical integration are, for example, 1 nm intervals.

**2.** The adhesive sheet according to claim 1, wherein
the colored adhesive layer does not comprise a dye having a main absorption wavelength band in a wavelength range of 390 nm to 435 nm.

**3.** The adhesive sheet according to claim 1 or 2, wherein
the UV absorbing layer is an adhesive layer comprising a UV absorber.

**4.** The adhesive sheet according to any one of claims 1 to 3, wherein
the UV absorbing layer is a transparent substrate having a UV shielding rate of 85% or more according to JIS L 1925.

**5.** The adhesive sheet according to any one of claims 1 to 4, wherein
the colored adhesive layer comprises at least one or more of radical a radical scavenger, peroxide decomposer, and singlet oxygen quencher.

**6.** The adhesive sheet according to any one of claims 1 to 5, wherein

the colored adhesive layer comprises a radical scavenger; and
the radical scavenger contains a hindered amine light stabilizer with a molecular weight of 2,000 or more.

**7.** The adhesive sheet according to any one of claims 1 to 6, wherein

the colored adhesive layer comprises a singlet oxygen quencher; and
the singlet oxygen quencher contains any of dialkyl phosphate, dialkyldithiocarbamate, benzenedithiol, and transition metal complexes thereof.

**8.** The adhesive sheet according to any one of claims 1 to 7, wherein
the first colorant, the second colorant, and the third colorant contained in the colored adhesive layer contain one or more compounds selected from a group consisting of compounds having a structure of any of a porphyrin structure, merocyanine structure, phthalocyanine structure, azo structure, cyanine structure, squarylium structure, coumarin structure, polyene structure, quinone structure, tetradiporphyrin structure, pyrromethene structure, and indigo structure, and metal complexes thereof.

**9.** The adhesive sheet according to any one of claims 1 to 8, further comprising
an oxygen barrier layer provided closer to the UV absorbing layer than the colored adhesive layer, the oxygen barrier layer having an oxygen permeability of 10 $cc/m^2 \cdot day \cdot atm$ or less.

**10.** An optical sheet comprising

the adhesive sheet according to any one of claims 1 to 9; and
an optical function layer which is disposed on an external light-incident side with respect to the UV absorbing layer and reduces reflection of the external light, wherein
the optical function layer is either an antiglare layer, or an antireflection layer including a high refractive index layer or a low refractive index layer.

**11.** The optical sheet according to claim 10, further comprising an antistatic layer or an antifouling layer.

**12.** A display device comprising

a luminescent layer; and
the adhesive sheet according to any one of claims 1 to 9 or the optical sheet according to claim 10 or 11, the

adhesive sheet or the optical sheet being disposed to face a light emission surface of the luminescent layer from above in a traveling direction of light emitted from the luminescent layer.

**13.** An adhesive layer-forming composition comprising

an adhesive, a dye, and an additive, wherein
the dye contains at least one of a first colorant in which a maximum absorption wavelength is in a range of 470 nm or more and 530 nm or less and a half width of absorption spectrum thereof is in a range of 15 nm or more and 45 nm or less, and a second colorant in which a maximum absorption wavelength is in a range of 560 nm or more and 620 nm or less and a half width of absorption spectrum thereof is in a range of 15 nm or more and 55 nm or less, and contains a third colorant in which, in a wavelength range of 400 nm or more and 780 nm or less, a wavelength with a lowest transmittance is in a range of 650 nm or more and 780 nm or less; and
the additive contains at least one of a radical scavenger, peroxide decomposer, and singlet oxygen quencher.

**14.** The adhesive layer-forming composition according to claim 13, wherein
the adhesive layer-forming composition contains no dye having a main absorption wavelength band in a wavelength range of 390 nm to 435 nm.

FIG.1

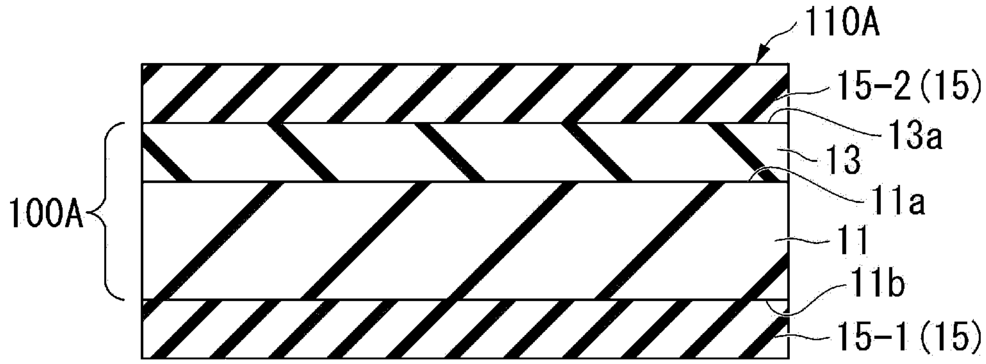


FIG.2

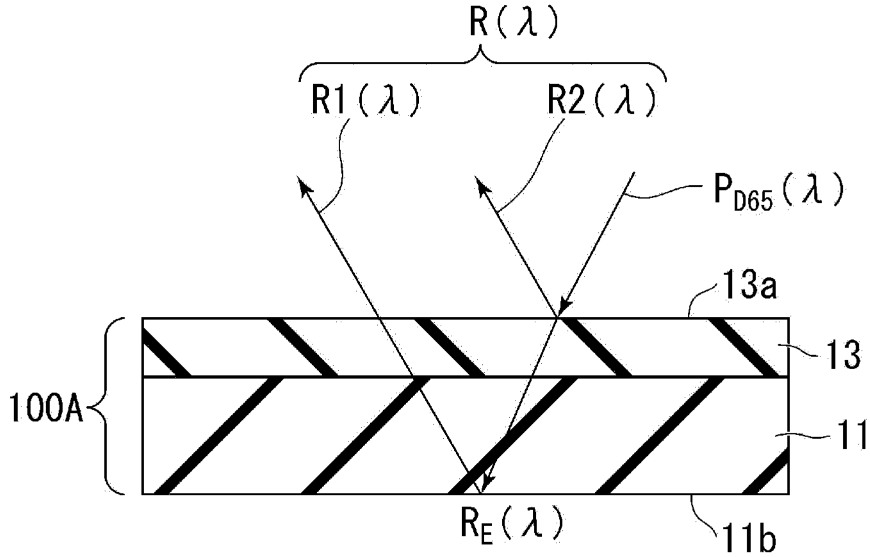


FIG.3

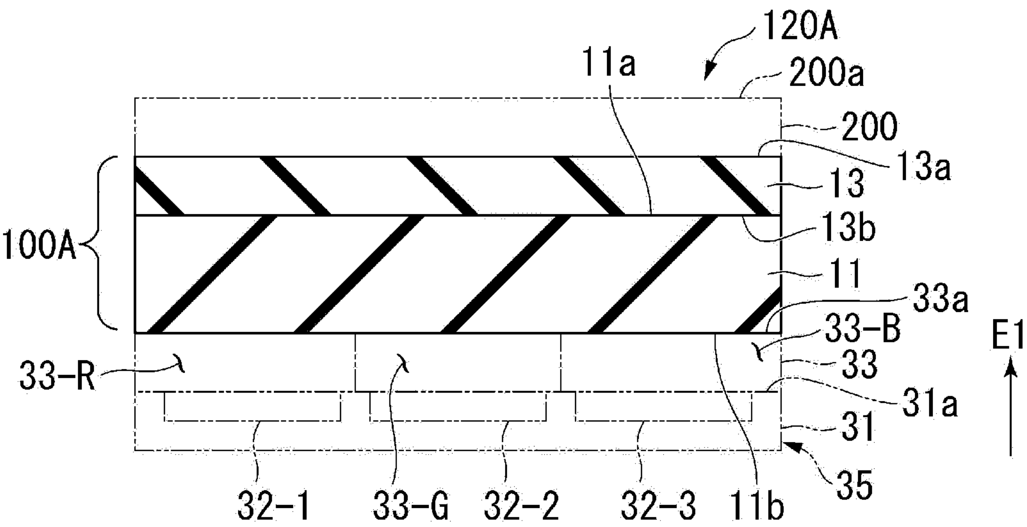

FIG.4

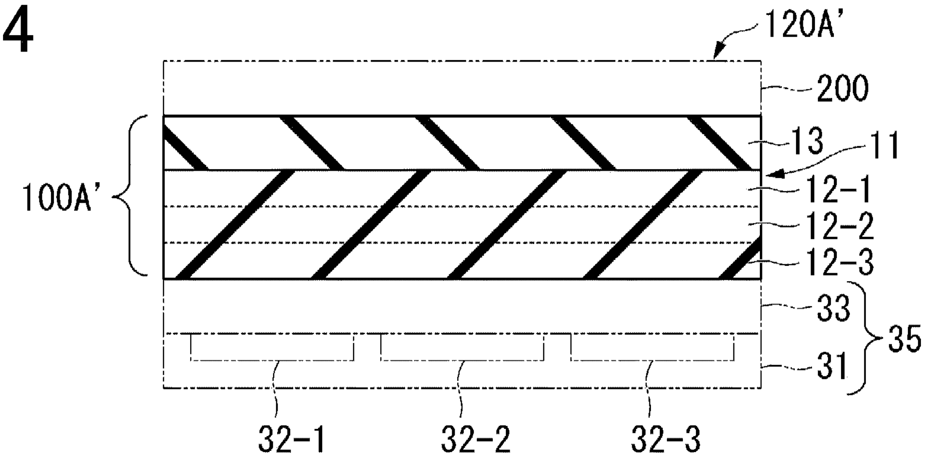


FIG.5

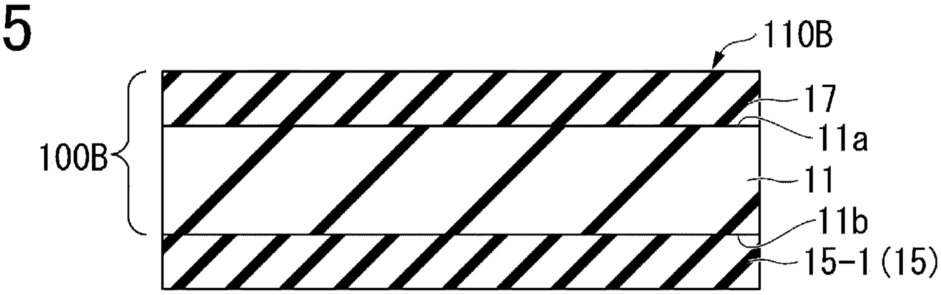


FIG.6

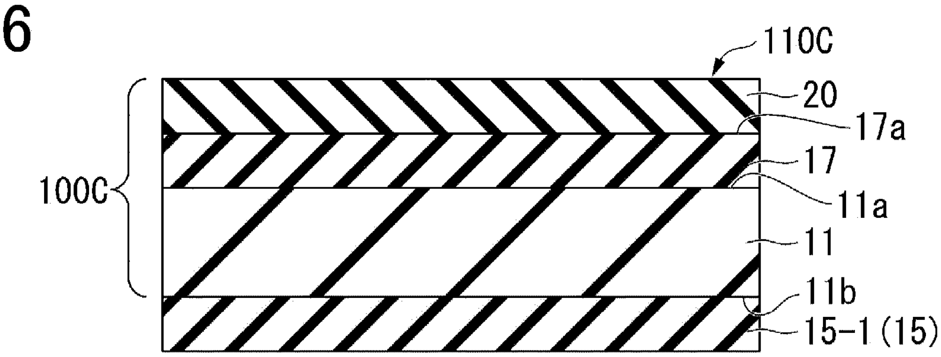


FIG.7

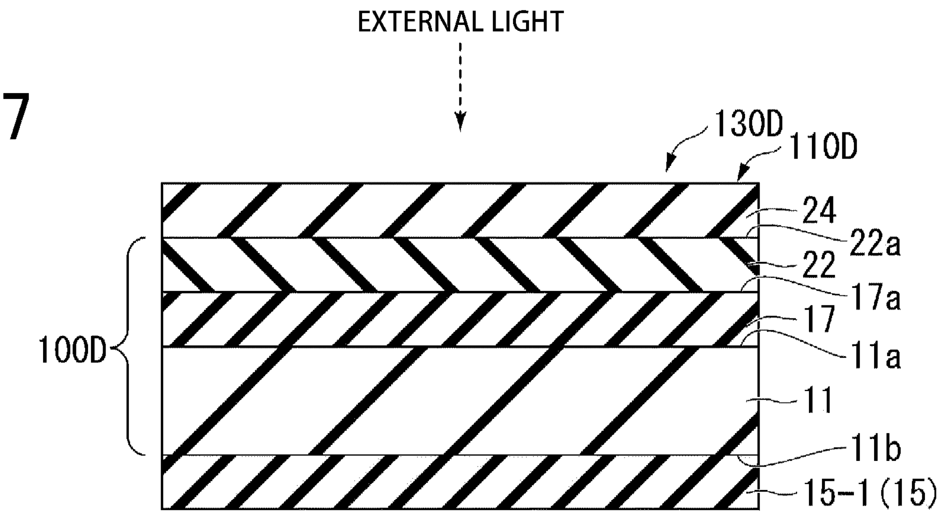

FIG.8

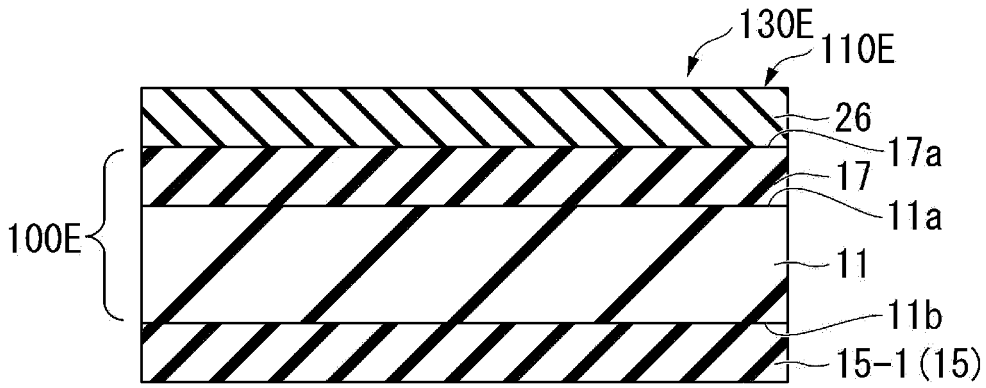


FIG.9

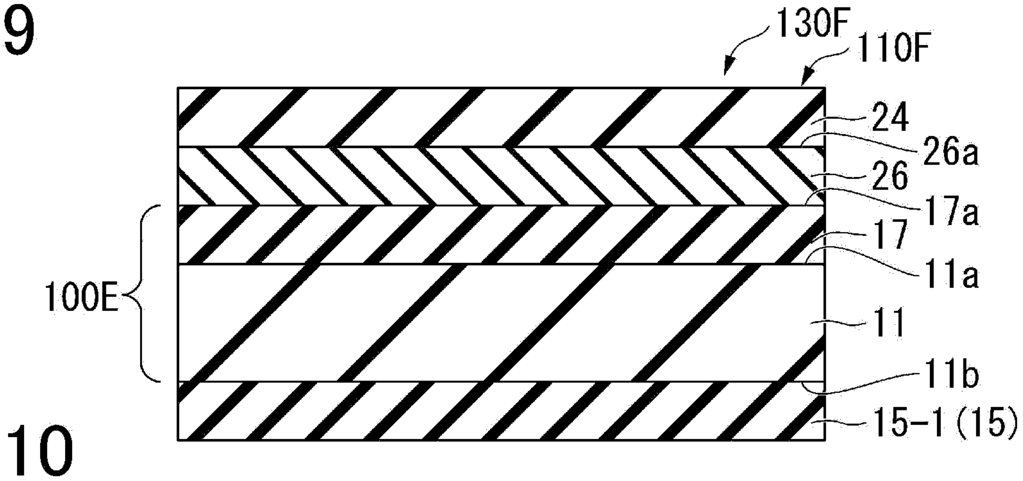


FIG.10

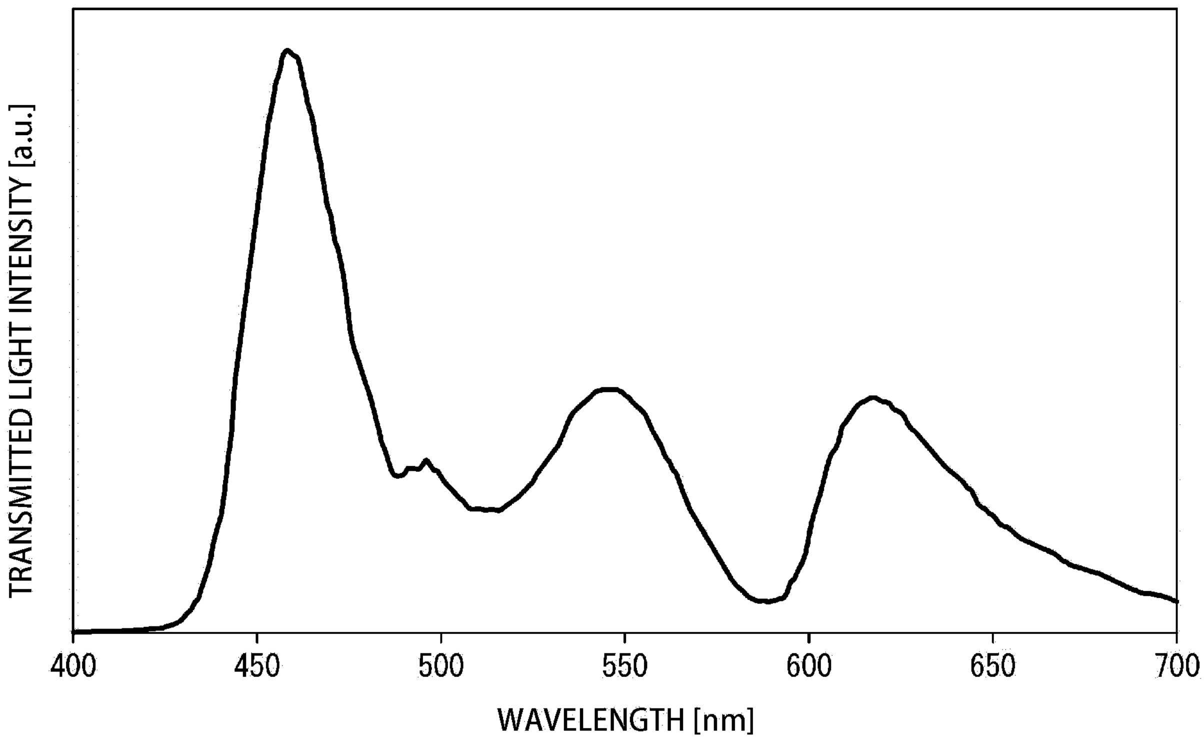

FIG.11

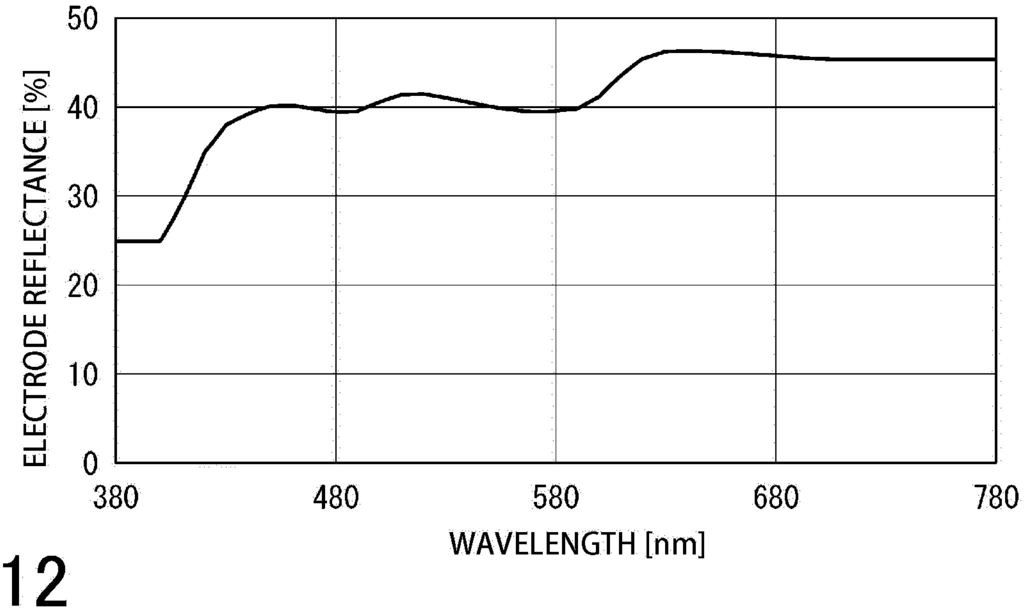
50
40
30
20
10
0
ELECTRODE REFLECTANCE [%]
380
480
580
680
780
WAVELENGTH [nm]

FIG.12

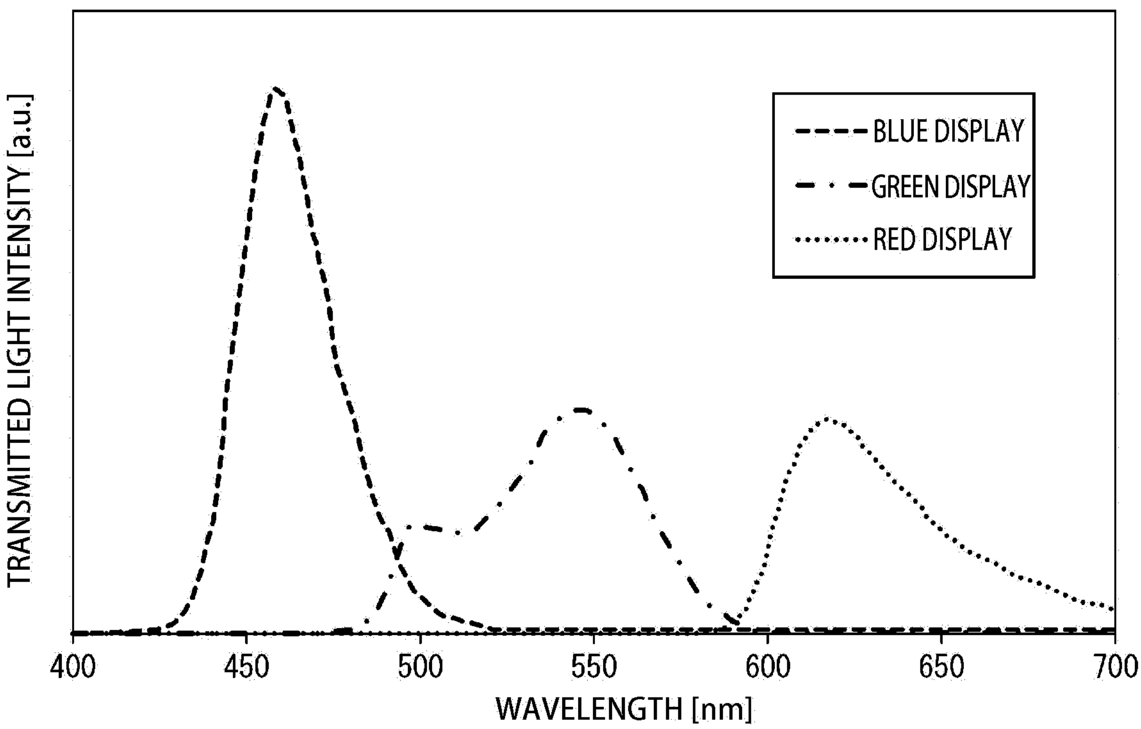
TRANSMITTED LIGHT INTENSITY [a.u.]
BLUE DISPLAY
GREEN DISPLAY
RED DISPLAY
400
450
500
550
600
650
700
WAVELENGTH [nm]

## INTERNATIONAL SEARCH REPORT

International application No.
**PCT/JP2022/010930**

**A. CLASSIFICATION OF SUBJECT MATTER**

***G02B 5/22***(2006.01)i; ***C09K 3/00***(2006.01)i; ***G02B 1/11***(2015.01)i; ***G02B 1/16***(2015.01)i; ***G02B 1/18***(2015.01)i; ***G02B 5/00***(2006.01)i; ***G02B 5/02***(2006.01)i; ***G09F 9/00***(2006.01)i; ***G09F 9/30***(2006.01)i
FI: G02B5/22; G02B1/16; G02B1/18; G02B1/11; G02B5/00 B; G09F9/30 365; G09F9/00 307B; G09F9/00 313; G09F9/30 349A; G09F9/30 349Z; C09K3/00 104; G02B5/02 B

According to International Patent Classification (IPC) or to both national classification and IPC

**B. FIELDS SEARCHED**

Minimum documentation searched (classification system followed by classification symbols)

G02B5/22; C09K3/00; G02B1/11; G02B1/16; G02B1/18; G02B5/00; G02B5/02; G09F9/00; G09F9/30

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2019-0109988 A (SAMSUNG SDI CO., LTD.) 27 September 2019 (2019-09-27) claims 1, 4, paragraphs [0003], [0042], [0045]-[0046], [0182] | 1-14 |
| Y | JP 2001-147319 A (FUJI PHOTO FILM CO LTD) 29 May 2001 (2001-05-29) paragraphs [0028]-[0029], [0136], [0191]-[0192], fig. 1 | 1-14 |
| Y | WO 2019/065021 A1 (FUJIFILM CORP) 04 April 2019 (2019-04-04) paragraph [0039] | 6 |
| Y | JP 2009-031733 A (NITTO DENKO CORP) 12 February 2009 (2009-02-12) paragraphs [0010], [0073] | 9 |
| A | JP 2002-071940 A (FUJI PHOTO FILM CO LTD) 12 March 2002 (2002-03-12) entire text, all drawings | 1-14 |
| A | KR 10-2020-0118555 A (SAMSUNG SDI CO., LTD.) 16 October 2020 (2020-10-16) paragraph [0238] | 1-14 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 May 2022** | **24 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

INTERNATIONAL SEARCH REPORT

International application No.
**PCT/JP2022/010930**

C. DOCUMENTS CONSIDERED TO BE RELEVANT

| Category* | Citation of document, with indication, where appropriate, of the relevant passages | Relevant to claim No. |
|---|---|---|
| A | JP 2019-056865 A (TOMOEGAWA PAPER CO LTD) 11 April 2019 (2019-04-11) entire text, all drawings | 1-14 |

Form PCT/ISA/210 (second sheet) (January 2015)

**INTERNATIONAL SEARCH REPORT**
**Information on patent family members**

International application No.
**PCT/JP2022/010930**

| Patent document cited in search report | Publication date (day/month/year) | Patent family member(s) | Publication date (day/month/year) |
|---|---|---|---|
| KR 10-2019-0109988 A | 27 September 2019 | (Family: none) | |
| JP 2001-147319 A | 29 May 2001 | US 6307671 B1<br>column 6, lines 15-51, column 55, lines 36-47, column 71, line 44 to column 72, line 11, fig. 1B-1D | |
| WO 2019/065021 A1 | 04 April 2019 | US 2020/0217999 A1<br>paragraph [0115]<br>TW 201915097 A | |
| JP 2009-031733 A | 12 February 2009 | US 2010/0103355 A1<br>paragraphs [0008], [0082]<br>WO 2009/004833 A1<br>KR 10-2009-0035468 A<br>CN 101542329 A<br>TW 200902635 A | |
| JP 2002-071940 A | 12 March 2002 | (Family: none) | |
| KR 10-2020-0118555 A | 16 October 2020 | (Family: none) | |
| JP 2019-056865 A | 11 April 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021040751 A
- JP 2019056865 A
- JP 5917659 B